(19) Europäisches Patentamt
European Patent Office
Office européen des brevets

(11) **EP 1 959 475 B1**

(12) **EUROPÄISCHE PATENTSCHRIFT**

(45) Veröffentlichungstag und Bekanntmachung des Hinweises auf die Patenterteilung:
**01.02.2012 Patentblatt 2012/05**

(21) Anmeldenummer: **08002645.3**

(22) Anmeldetag: **13.02.2008**

(51) Int Cl.:
*H01J 37/26* (2006.01)   *H01J 37/04* (2006.01)
*H01J 37/09* (2006.01)

(54) **Phasenschiebendes Element und Teilchenstrahlgerät mit phasenschiebenden Element**

Phase shifting element and particle beam device with phase shifting element

Elément à décalage de phase et appareil de rayonnement à particules doté d'un élément de à décalage de phase

(84) Benannte Vertragsstaaten:
**CZ DE GB NL**

(30) Priorität: **14.02.2007 DE 102007007923**

(43) Veröffentlichungstag der Anmeldung:
**20.08.2008 Patentblatt 2008/34**

(73) Patentinhaber:
• **Carl Zeiss NTS GmbH
73447 Oberkochen (DE)**
• **Max-Planck-Gesellschaft zur Förderung der Wissenschaften e.V.
80539 München (DE)**

(72) Erfinder:
• **Rose, Harald, Prof. Dr.
64287 Darmstadt (DE)**
• **Schröder, Rasmus, Dr.
69118 Heidelberg (DE)**
• **Benner, Gerd, Dr.
73434 Aalen (DE)**
• **Barton, Bastian
60314 Frankfurt (DE)**

(74) Vertreter: **Tongbhoyai, Martin
Patentanwälte Freischem
Salierring 47-53
50677 Köln (DE)**

(56) Entgegenhaltungen:
**WO-A-2006/017252    DE-A1- 3 829 233
JP-A- 2006 012 795**

• **SCHULTHEISS K ET AL: "Fabrication of a Boersch phase plate for phase contrast imaging in a transmission electron microscope" REVIEW OF SCIENTIFIC INSTRUMENTS, AIP, MELVILLE, NY, US, Bd. 77, Nr. 3, 10. März 2006 (2006-03-10), Seiten 33701-033701, XP012092749 ISSN: 0034-6748**
• **GERTHSEN D ET AL: "Effect of a Physical Phase Plate on Contrast Transfer in an Aberration-Corrected Transmission Electron Microscope" MICROSCOPY AND MICROANALYSIS, SPRINGER, NEW YORK, NY, US, Bd. 13, Nr. suppl. 2, 1. Januar 2007 (2007-01-01), Seiten 126-127, XP007905960 ISSN: 1431-9276**

EP 1 959 475 B1

**Beschreibung**

Die Erfindung betrifft ein phasenschiebendes Element zum Schieben einer Phase zumindest eines Teils eines Teilchenstrahls sowie ein Teilchenstrahlgerät mit einem derartigen phasenschiebenden Element.

Bereits seit langem ist in der Lichtmikroskopie die Untersuchung von biologischen Proben mittels Phasenkontrastes bekannt. Mit einem sogenannten Phasenring, welcher in der hinteren Brennebene eines Objektivs eines Lichtmikroskops angeordnet ist, wird die von einer zu untersuchenden Probe kommende Strahlung, welche gebeugte und nicht gebeugte Anteile enthält, in nullter Beugungsordnung um 90° (also π/2) phasenverschoben. Die Interferenz der höheren Beugungsordnungen mit dem phasenverschobenen Strahl liefert ein kontrastreiches Bild (Bild mit Phasenkontrast).

Die Anwendung eines derartigen Verfahrens auf die Elektronenmikroskopie, insbesondere die Transmissionselektronenmikroskopie, war lange Zeit nicht möglich. Aber gerade dort ist die Anwendung einer Phasenkontrastuntersuchung von Vorteil, da biologische Proben im Grunde sehr dünn ausgebildet sind und meist aus sehr leichten Atomen bestehen, so daß sie praktisch für einfallende Elektronen bzw. Elektronenwellen transparent sind. Derartige Proben werden auch phasenschwache Objekte genannt. Anstatt die Amplitude einer einfallenden Elektronenwelle zu modifizieren, bewirken phasenschwache Objekte nur eine Phasenverschiebung der einfallenden Elektronenwelle. Um einen besseren Phasenkontrast zu erhalten, ist eine zusätzliche Phasenverschiebung von 90° (also π/2) zwischen den gestreuten bzw. gebeugten und den ungestreuten bzw. ungebeugten Elektronen notwendig.

Es wurden bereits einige Vorschläge gemacht, um einen Phasenkontrast in der Transmissionselektronenmikroskopie zu erzielen.

Zum einen wurde vorgeschlagen, den Phasenkontrast in einem Transmissionselektronenmikroskop (nachfolgend TEM genannt), welches eine Objektivlinse aufweist, durch Defokussierung der Objektivlinse und der sphärischen Aberration der Objektivlinse zu erzielen. Von Nachteil ist hierbei jedoch, daß durch diese Vorgehensweise nur eine raumfrequenzabhängige Phasenverschiebung erzielt wird, so daß der erzielte Phasenkontrast ebenfalls raumfrequenzabhängig ist. Zu untersuchende Proben mit sehr geringen Raumfrequenzen weisen daher einen sehr geringen Kontrast auf. Dieser Zusammenhang ist mittels der Phasenkontrast-Transferfunktion (PCTF oder auch CTF abgekürzt) näher beschreibbar (siehe hierzu beispielsweise *Optimizing phase contrast in transmission electron microscopy with an electrostatic (Boersch) phase plate*, E. Majorovits et. al, Ultramicroscopy 107 (2007) 213-226).

Zum anderen wurde vorgeschlagen, eine sogenannte Zernike-Phasenplatte einzusetzen, die eine einheitliche Phasenverschiebung von gestreuten oder ungestreuten Elektronen für alle Raumfrequenzen zur Verfügung stellt. Eine derartige Phasenplatte besteht beispielsweise aus einem dünnen Kohlenstoff-Film, der mit einem kleinen Loch versehen ist. Dieser Kohlenstoff-Film wird in der hinteren Brennebene einer Objektivlinse eines TEM angeordnet. Ungestreute Elektronen treten durch das kleine Loch des Kohlenstoff-Films hindurch, während gestreute Elektronen auf den Kohlenstoff-Film selbst treffen und eine Phasenverschiebung von 90° (π/2) aufgrund eines homogenen isotropen Potentials (inneres Potential, Coulomb-Potential) des Kohlenstoff-Films erfahren können. Es hat sich aber gezeigt, daß der Kohlenstoff-Film sehr schnell kontaminiert. Insbesondere das kleine Loch setzt sich sehr schnell zu. Ferner ist von Nachteil, daß sich der Kohlenstoff-Film sehr schnell auflädt.

Ferner wird zur Phasenveschiebung auch eine sogenannte Hilbert-Phasenplatte verwendet, die - wie die Zernike-Phasenplatte - ebenfalls aus einem dünnen Kohlenstoff-Film ausgebildet sein kann und die Phasenverschiebung eines Halbraumes bewirkt. Die Hilbert-Phasenplatte weist jedoch dieselben Nachteile wie die Zernike-Phasenplatte auf.

Eine alternative Form der Phasenverschiebung bei einem TEM wird durch Verwendung einer Boersch-Phasenplatte erzielt, bei der ein Elektronenstrahl einem elektrostatischen Potential ausgesetzt wird. Ein Aufbau einer solchen Boersch-Phasenplatte ist beispielsweise aus der EP 782 170 A2 bekannt. Diese weist eine Ringelektrode und eine Halterungseinrichtung auf. Die Ringelektrode besteht aus einer ringförmigen Platte mit einer zentralen Öffnung und einem äußeren Rand. Die Halterungseinrichtung wird durch zwei gerade Träger gebildet, die einander gegenüberliegend angeordnet sind. Bei dieser bekannten Boersch-Phasenplatte durchsetzen die an einer Probe ungestreuten bzw. ungebeugten Elektronen die zentrale Öffnung, während die gestreuten bzw. gebeugten Elektronen außerhalb der ringförmigen Platte verlaufen. In der zentralen Öffnung ist ein elektrostatisches Feld gebildet, welches eine Phasenverschiebung der durch die zentrale Öffnung tretenden Elektronen bewirkt. Die bekannte Boersch-Phasenplatte weist jedoch den Nachteil auf, daß insbesondere aufgrund der Träger eine Abschattung von Teilstrahlen bewirkt wird, welche nicht mehr zur Interferenz beitragen so daß es zu einem Informationsverlust kommt.

Eine weitere Boersch-Phasenplatte ist aus der WO 03/068399 A2 bekannt. Diese Druckschrift betrifft eine Phasenplatte mit einer Ringelektrode, die als Platte mit einer Öffnung und einem umlaufenden äußeren Rand gebildet ist. Ferner ist eine Halteeinrichtung vorgesehen, welche Träger umfaßt. Die Träger sind am äußeren Rand der Ringelektrode angebracht und dienen der Positionierung der Ringelektrode in einem TEM. Diese bekannte Phasenplatte zeichnet sich dadurch aus, daß die Halteeinrichtung nicht-zentralsymmetrisch ausgebildet ist und für jeden Träger am relativ zur Mitte der Öffnung gegenüberliegenden äußeren Rand der Platte kein weiterer Träger angeordnet ist. Die bekannte Phasenplatte ist in der hinteren Brennebene eines Objektivs eines TEM angeordnet. Aufgrund der Träger der Phasenplatte erfolgt zwar in der hinteren Brennebene des Objektivs eine Abschattung eines Teilbereichs der gestreuten Elektronen. Durch die nicht-zentralsymmetrische Anordnung bleiben die gestreuten Elektronen in einem weiteren Teilbereich, der zum abgeschatteten Teilbereich zentralsymmetrisch ist, unbeeinflußt. Aufgrund von Symmetriebeziehungen ermöglicht diese Phasenplatte eine Rekonstruktion der zunächst durch die trägerbedingte Abschattung verloren gegangenen Bildinformation. Von Nachteil bei dieser bekannten Phasenplatte ist aber weiterhin, daß ein Teilbereich der gestreuten Elektronen abgeschattet wird und daß somit die Bildinformation teilweise rekonstruiert werden muß.

Aus der DE 102 00 645 A1 ist ein Elektronenmikroskop bekannt, das ebenfalls ein phasenschiebendes Element aufweist. Dieses phasenschiebende Element ist ringförmig mit einer zentralen Öffnung ausgebildet und kann demzufolge an seinem Außenumfang gefaßt sein, so daß keine freitragenden oder nahezu freitragenden Strukturen erforderlich sind.

Der Erfindung liegt daher die Aufgabe zugrunde, ein phasenschiebendes Element und ein Teilchenstrahlgerät mit einem phasenschiebenden Element anzugeben, bei denen einen Teilchenstrahl abschattende Bauelemente vermieden werden, so daß ein guter Informationsgehalt erzielt wird, und bei denen der Phasenkontrast im wesentlichen raumfrequenzunabhängig bei Defokus gleich Null (Gaußscher Fokus) ist.

Diese Aufgabe wird erfindungsgemäß mit einem phasenschiebenden Element mit den Merkmalen des Anspruchs 1 bzw. 2 gelöst. Ein erfindungsgemäßes Teilchenstrahlgerät ist durch die Merkmale des Anspruchs 26 charakterisiert. Weitere Merkmale der Erfindung ergeben sich aus den weiteren Ansprüchen sowie der nachfolgenden Beschreibung und den Figuren.

Das erfindungsgemäße phasenschiebende Element ist zum Schieben der Phase zumindest eines Teiles eines Teilchenstrahls vorgesehen. Es weist mindestens ein Mittel zur Erzeugung eines inhomogenen Potentials auf, das auf den Teilchenstrahl einwirkt. Alternativ oder auch zusätzlich ist es vorgesehen, mindestens ein Mittel zur Erzeugung eines anisotropen Potentials vorzusehen.

Insbesondere ist es vorgesehen, das erfindungsgemäße phasenschiebende Element in einem Elektronenstrahlgerät, beispielsweise in einem Transmissionselektronenmikroskop, einzusetzen. Durch Wahl eines entsprechenden inhomogenen und/oder anisotropen Potentials ist die Phasenverschiebung beliebig einstellbar. Bevorzugt ist für einen guten Abbildungskontrast eine Phasenverschiebung von 90° ($\pi/2$). Andere Phasenverschiebungen sind aber durchaus auch bei der Erfindung vorgesehen. Die Erfindung sieht demnach vor, daß die von einem Objekt ungestreuten Teilchen relativ zu den von dem Objekt gestreuten Teilchen eine Phasenverschiebung erfahren. Mit anderen Worten ausgedrückt, erfolgt eine relative Phasenverschiebung zwischen dem Teilchenstrahl nullter Beugungsordnung und den gebeugten Teilchenstrahlen höherer Beugungsordnung.

Das erfindungsgemäße phasenschiebende Element weist den Vorteil auf, daß keine störenden Halteeinrichtungen mehr benötigt werden. Somit wird bei der Erfindung im Unterschied zum Stand der Technik kein Teil eines Teilchenstrahls durch Abschattung ausgeblendet. Man erhält somit stets ein gutes Objekt-Signal und demnach eine gute Bildinformation. Zudem gewährleistet die Verwendung eines inhomogenen Potentials, daß der erhaltene Phasenkontrast raumfrequenzunabgängig bei Defokus gleich Null (Gaußscher Fokus) bleibt.

Bei einem ersten Ausführungsbeispiel des erfindungsgemäßen phasenschiebenden Elements ist das Mittel zur Erzeugung eines inhomogenen Potentials zur Erzeugung eines inhomogenen elektrischen Potentials ausgebildet. Dieses läßt sich einfach realisieren. Ferner ist mit diesem insbesondere ein raumfrequenzunabängiger Phasenkontrast erzielbar. Alternativ hierzu ist vorgesehen, daß das Mittel zur Erzeugung eines inhomogenen Potentials zur Erzeugung eines inhomogenen magnetischen Potentials vorgesehen ist. Hierzu ist beispielsweise die Verwendung mindestens eines Permanentmagneten vorgesehen. Das Vorstehende gilt auch für ein entsprechendes anisotropes Potential.

Ferner ist es erfindungsgemäß vorgesehen, daß das phasenschiebende Element mindestens eine Öffnung aufweist, die vorzugsweise als durchgehende Öffnung durch das Material des phasenschiebenden Elements ausgebildet ist. Es wird aber ausdrücklich darauf hingewiesen, daß die Öffnung nicht durchgehend ausgebildet sein muß. Beispielsweise sind auch Ausführungsformen der Erfindung vorgesehen, deren Öffnung nicht durchgehend ausgebildet sind. Beispielsweise sind Öffnungen vorgesehen, die mit einer dünnen Folie abgeschlossen sind. Die Öffnung ist erfindungsgemäß in zu einer Ebene des phasenschiebenden Elements senkrechter Richtung nicht rotationssymmetrisch ausgebildet, um so ein gutes und stark lokalisiertes inhomogenes und/oder anisotropes Potential zu erzeugen.

Bei einer weiteren Ausführungsform ist es vorgesehen, daß das phasenschiebende Element genau eine Öffnung aufweist. Durch die oben genannte mindestens eine Öffnung bzw. durch die genau eine Öffnung treten die gestreuten bzw. ungestreuten Teilchenstrahlen (beispielsweise Elektronenstrahlen in einem TEM) hindurch, wobei der ungestreute Teilchenstrahl (also der Teilchenstrahl nullter Beugungsordnung) zu den Teilchenstrahlen höherer Beugungsordnung eine relative Phasenverschiebung erfährt. Die Interferenz der Teilchenstrahlen höherer Beugungsordnung mit dem relativ phasenverschobenen Teilchenstrahl liefert ein ausreichend gutes kontrastreiches Bild.

Besonders bevorzugt ist es vorgesehen, daß das phasenschiebende Element eine erste Element-Ausdehnung entlang einer ersten Achse und eine zweite Element-Ausdehnung entlang einer zweiten Achse aufweist, wobei die erste Achse nicht parallel zur zweiten Achse angeordnet ist. Die Öffnung des phasenschiebenden Elements erstreckt sich bei diesem Ausführungsbeispiel sowohl entlang der ersten Achse als auch entlang der zweiten Achse.

Ferner zeichnet sich eine Ausgestaltung der Erfindung dadurch aus, daß die Öffnung eine erste Öffnungsausdehnung entlang der ersten Achse und eine zweite Öffnungsausdehnung entlang der zweiten Achse aufweist, wobei die erste Öffnungsausdehnung größer als die zweite Öffnungsausdehnung ist. Insbesondere spannen die erste Achse und die zweite Achse eine Ebene auf (beispielsweise die Oberfläche des phasenschiebenden Elements), an der die Öffnung angeordnet ist. Die Öffnungsausdehnungen sollten derart gewählt sein, daß ein Beugungsbild, welches abgebildet werden soll, durch die Öffnung treten kann. Bei einer besonderen Ausführungsform liegt die erste Öffnungsausdehnung dabei bevorzugt in einem Bereich von 20 μm bis 200 μm, vorzugsweise im Bereich zwischen 40 μm bis 180 μm und noch bevorzugter im Bereich zwischen 50 μm und 150 μm. Die zweite Öffnungsausdehnung liegt bevorzugt im Bereich zwischen 1 μm bis 20 μm und bevorzugter zwischen 2 μm bis 5 μm.

Die erste Achse ist vorzugsweise senkrecht zur zweiten Achse angeordnet. Bevorzugt weist das phasenschiebende Element auch eine dritte Achse, auf welche nicht parallel zur ersten Achse und nicht parallel zur zweiten Achse, sondern bevorzugt senkrecht sowohl zur ersten Achse als auch zur zweiten Achse angeordnet ist. Die Öffnung weist dann eine dritte Öffnungsausdehnung auf, die sich entlang der dritten Achse erstreckt, wobei die dritte Öffnungsausdehnung im Grunde der Höhe des phasenschiebenden Elements entspricht. Diese ist im Grunde frei wählbar und kann zwischen einigen μm bis zu einigen mm betragen.

Insbesondere ist es vorgesehen, daß die Öffnung schlitzförmig ausgebildet ist. Hierunter wird insbesondere die Ausbildung in Form eines Rechtecks verstanden. Es wird explizit darauf hingewiesen, daß die schlitzförmige Ausbildung nicht auf die Form eines Rechtecks eingeschränkt ist, sondern jede erdenkliche Form aufweisen kann, mit der die schlitzförmige Ausgestaltung erzielbar ist. Auch ist es bei einer weiteren Ausführungsform zusätzlich oder alternativ vorgesehen, daß die Öffnung kreuzförmig ausgebildet ist.

Bei einer weiteren Ausgestaltung des erfindungsgemäßen phasenschiebenden Elements ist das phasenschiebende Element mehrschichtig ausgebildet. Vorzugsweise ist dabei vorgesehen, daß das phasenschiebende Element mindestens eine Elektrode aufweist. Es sind aber auch Ausführungsformen vorgesehen, bei denen mehr als eine Elektrode an dem phasenschiebenden Element angeordnet sind. Die Elektrode ist bei einem bevorzugten Ausführungsbeispiel aus Gold gebildet. Ferner ist sie über mindestens einen elektrischen Leiter mit einer Steuereinheit verbunden, um ein inhomogenes und/oder anisotropes Potential zu erzeugen.

Bei einer bevorzugten Ausführungsform der Erfindung ist vorgesehen, die Elektrode zu segmentieren, so daß diese aus einzelnen Elektrodensegmenten besteht. Diese Elektrodensegmente sind bevorzugt einzeln ansteuerbar.

Zusätzlich oder alternativ zu einer Segmentierung einer einzelnen Elektrode ist es bei einer anderen Ausführungsform der Erfindung vorgesehen, eine separate erste Elektrode und eine separate zweite Elektrode vorzusehen, die ebenfalls bevorzugt einzeln ansteuerbar sind.

Ferner ist vorzugsweise vorgesehen, daß die Elektrode eine erste Seite und eine zweite Seite aufweist. An der ersten Seite der Elektrode ist ein erster Isolator angeordnet. Zusätzlich ist vorzugsweise vorgesehen, an der zweiten Seite der Elektrode einen zweiten Isolator anzuordnen. Der erste Isolator und/oder der zweite Isolator ist/sind bevorzugt aus $Al_2O_3$ gebildet. Bei einer weiteren Ausführungsform ist vorgesehen, daß an dem ersten Isolator eine erste Abschirmeinheit angeordnet ist. Zusätzlich hierzu ist an dem zweiten Isolator eine zweite Abschirmeinheit angeordnet. Bevorzugt ist/sind die erste Abschirmeinheit und/oder die zweite Abschirmeinheit aus Gold gebildet.

Die vorbeschriebene Ausführungsform bzw. die vorbeschriebenen Ausführungsformen sind einfach zu realisieren (beispielsweise mit Lithograhpieverfahren und/oder Sputterverfahren). Ferner sind sie leicht von außen steuerbar. Insbesondere ist es möglich, ein inhomogenes oder ein anisotropes Potential (beispielsweise ein inhomogenes elektrisches Potential) genau derart zu steuern, daß man eine gewünschte Phasenverschiebung erhält.

Bei einer weiteren Ausgestaltung der Erfindung weist das phasenschiebende Element eine Drifteinheit auf. Beispielsweise ist es vorgesehen, die Öffnung des phasenschiebenden Elements als eine Drifteinheit auszubilden oder in der Öffnung eine Drifteinheit anzuordnen. Der Aufbau und die Funktion von Drifteinheiten sind seit langem bekannt, so daß hierauf nicht näher eingegangen wird.

Bei einer weiteren Ausführungsform der Erfindung ist es vorgesehen, daß das zuvor beschriebene phasenschiebende Element zusätzlich mindestens einen Abschnitt mit einem inneren Potential aufweist. Dies ist demnach die Kombination des erfindungsgemäßen phasenschiebenden Elementes mit dem bereits bekannten Stand der Technik.

Die Erfindung betrifft auch ein System mit mindestens einem ersten phasenschiebenden Element und mit mindestens einem zweiten phasenschiebenden Element, wobei sowohl das erste phasenschiebende Element als auch das zweite phasenschiebende Element mindestens eines der obengenannten Merkmale oder Merkmalskombinationen aufweist. Insbesondere ist es vorzugsweise vorgesehen, daß das System eine optische Achse aufweist und daß das erste phasenschiebende Element und das zweite phasenschiebende Element entlang der optischen Achse angeordnet sind. Hierbei ist das zweite phasenschiebende Element hinter dem ersten phasenschiebenden Element angeordnet.

Das erfindungsgemäße System ist insbesondere dann von Vorteil, wenn eine kreuzförmige Ausbildung der Öffnung des phasenschiebenden Elements verwendet werden soll. Diese kann gemäß dem erfindungsgemäßen System auch durch zwei hintereinander geschaltete phasenschiebende Elemente realisiert werden, die jeweils eine in eine Vorzugsrichtung ausgerichtete Öffnung (beispielsweise ein rechteckförmiger Schlitz) aufweisen. Die phasenschiebenden Elemente sind derart hintereinander angeordnet, daß die Vorzugsrichtungen der Phasenverschiebung senkrecht zueinander angeordnet sind. Somit durchläuft ein Teilchenstrahl mit zwei Durchläufen praktisch eine kreuzförmige Öffnung.

Die Erfindung betrifft auch ein Teilchenstrahlgerät, das mit mindestens einem Objektiv versehen ist, welches eine hintere Brennebene aufweist. Ferner ist an dem Teilchenstrahlgerät mindestens eine erste Beugungslinse zur vergrö-βerten Abbildung der hinteren Brennebene des Objektivs in eine Beugungs-Zwischenbildebene angeordnet. Auch ist mindestens eine zweite Beugungslinse vorgesehen, die in der Beugungs-Zwischenbildebene angeordnet ist. Dabei wird unter "in der Beugungs-Zwischenbildebene" (hier und nachfolgend) zum einen genau in der Beugungs-Zwischenbildebene und zum anderen auch in der Nähe der Beugungs-Zwischenbildebene verstanden. Das erfindungsgemäße Teilchenstrahlgerät ist ferner mit mindestens einem Multipolelement und mit mindestens einem phasenschiebenden Element versehen, das mindestens eines der vorgenannten Merkmale oder Merkmalskombinationen aufweist und vorzugsweise in der Beugungs-Zwischenbildebene angeordnet ist.

Das erfindungsgemäße Teilchenstrahlgerät weist zusätzlich zu den bereits oben genannten Vorteilen den Vorteil auf, daß die hintere Brennebene und somit die Beugungsebene des Objektivs vergrößert in der Beugungs-Zwischenbildebene abgebildet wird. Dementsprechend kann das phasenschiebende Element entsprechend vergrößert ausgebildet sein, so daß aufgrund der nicht sehr hohen dimenionsmäßgen Anforderungen das phasenschiebende Element einfacher herstellbar ist. Ferner ist von Vorteil, daß die zweite Beugungslinse in oder im Bereich der Beugungs-Zwischenbildebene angeordnet ist, so daß die zweite Beugungslinse im Prinzip fast nur Einfluß auf die Lage der zu einer Gegenstandsebene des Objektivs konjugierten Bildebene hat.

Die vergrößerte Abbildung der Beugungsebene ist aufgrund des mindestens einen Multipolelements im Grunde linear-verzeichnet. Man spricht auch von einer anamorphotischen Abbildung. Die vergrößerte Abbildung der Beugungsebene ist dabei in Richtung zwei zueinander senkrecht angeordneten Achsen unterschiedlich groß. Das Verhältnis der Vergrößerung hinsichtlich dieser beiden Achsen wird als Aspektverhältnis bezeichnet. Das Aspektverhältnis beeinflußt und definiert die Dimensionen des phasenschiebenden Elements. Für die Erfindung ist ein Aspektverhältnis im Bereich von 1:10 bis 1:100 bevorzugt.

Bei einer Ausgestaltung des erfindungsgemäßen Teilchenstrahlgeräts weist das Teilchenstrahlgerät eine optische Achse auf. Ferner ist vom Objektiv in Richtung der zweiten Beugungslinse gesehen das mindestens eine Multipolelement angeordnet, welches der oben genannten anamorphotischen Abbildung der Beugungsebene dient. Vorzugsweise sind ein erstes Multipolelement und ein zweites Multipolelement vorgesehen, wobei vom Objektiv aus in Richtung der zweiten Beugungslinse die erste Beugungslinse, das erste Multipolelement, das zweite Multipolelement und die Beugungs-Zwischenbildebene angeordnet sind. Durch das vorbeschriebene Ausführungsbeispiel wird eine gute anamorphotische Abbildung der Beugungsebene gewährleistet.

Bei einer weiteren Ausführungsform sind auch ein drittes Multipolelement, ein viertes Multipolelement sowie eine Projektivlinse an dem erfindungsgemäßen Teilchenstrahlgerät angeordnet, wobei von der Beugungs-Zwischenbildebene in Richtung der Projektivlinse das dritte Multipolelement, das vierte Multipolelement und die Projektivlinse angeordnet sind. Vorzugsweise weist das Teilchenstrahlgerät auch ein fünftes Mutipolelement im Bereich der Beugungs-Zwischenbildebene auf, welches vorteilhaft in ein erstes Untermultipolelement und ein zweites Untermultipolelement aufgespalten ist. Die vorgenannte Anordnung von Multipolelementen gewährleistet, daß die anamorphotische Abbildung wieder kompensiert, also rückgängig gemacht wird. Ferner ist die Aufspaltung in zwei Untermultipolelemente insbesondere bei der Montage von Vorteil, da das phasenschiebende Element im Bereich der Beugungs-Zwischenbildebene angeordnet werden muß und durch die Aufspaltung ein besserer Zugang gewährt ist.

Bei einer bevorzugten Ausführungsform der Erfindung ist das Multipolelement oder ist mindestens eines der Multipolelemente mit mindestens einem magnetischen oder elektrischen Pol versehen. Je nach Anzahl der Pole lassen sich gewünschte Felder erzeugen, die für eine anamorphotische Abbildung notwendig sind. Vorzugsweise weist das Multipolelement oder mindestens eines der Multipolelemente ein Quadrupolfeld auf. Insbesondere ist es vorgesehen, das Mulipolelement oder mindestens eines der Multipolelemente als Quadrupolelement auszubilden.

Ferner ist es vorteilhaft, jedem Quadrupolelement ein Dipolfeld zu überlagern, so daß zweiachsige Doppelablenksysteme von zwei benachbarten Quadrupolelementen gebildet werden.

Bei einem weiteren Ausführungsbeispiel weist das Teilchenstrahlgerät mindestens sechs Quadrupolelemente auf, die antisymmetrisch zu der Beugungs-Zwischenbildebene erregbar sind, wobei jedem Quadrupolelement und der Beugungs-Zwischenbildebene jeweils ein Oktupol überlagert ist. Eine derartige Anordnung von Quadrupolelementen und Oktupolen ist zwar aus der DE 42 04 512 A1 bekannt, nicht aber im Zusammenhang mit einem phasenschiebenden Element. Dieses Ausführungsbeispiel gewährleistet zum einen eine anamorphotische Abbildung der Beugungsebene, wobei in der Abbildung das phasenschiebende Element angeordnet ist, und zum anderen eine Korrektur von Öffnungs- und chromatischen Fehlern des Teilchenstrahlgeräts.

Bei einem weiteren Ausführungsbeispiel des erfindungsgemäßen Teilchenstrahlgeräts weist das Teilchenstrahlgerät mindestens ein sechs Quadrupolelemente enthaltendes Quadrupol-Septuplet, wobei die Quadrupolelemente symmetrisch zu der Beugungs-Zwischenbildebene erregbar sind, sowie mindestens fünf innerhalb des Quadrupol-Septuplet erregbare Oktupole auf. Eine solche Anordnung ist aus der DE 101 59 454 A1 bekannt, nicht jedoch im Zusammenhang mit einem phasenschiebenden Element. Dieses Ausführungsbeispiel gewährleistet wiederum zum einen eine anamorphotische Abbildung der Beugungsebene und zum anderen eine Korrektur von Öffnungs- und chromatischen Fehlern des Teilchenstrahlgeräts.

Wie oben bereits erwähnt, ist bei einer bevorzugten Ausführungsform das Quadrupolelement oder ist mindestens eines der Quadrupoelemente elektrisch oder magnetisch ausgebildet. Auch ist bevorzugt vorgesehen, daß mindestens einer der Oktupole elektrisch und/oder magnetisch ausgebildet ist.

Auch sieht eine bevorzugte Ausführungsform des Teilchenstrahlgeräts vor, daß das Teilchenstrahlgerät mit einem Korrektor zur Korrektur von Aberrationen versehen ist, der beispielsweise wie oben beschrieben ausgebildet sein kann. Dabei ist es vorzugsweise vorgesehen, daß das Multipolelement (insbesondere das oben beschriebene System aus Quadrupolelementen) in Bezug auf eine Strahlrichtung des Teilchenstrahlgeräts vor und/oder hinter dem Korrektor angeordnet werden kann. Dieses Ausführungsbeispiel gewährleistet, daß im Falle einer Abbildung im Gaußschen Fokus eine nullstellenfreie Kontrastübertragung realisiert wird. Der Betrag der Phasenkontrasttransferfunktion variiert dabei zwischen dem Betrag 1 (d.h. optimaler Phasenkontrast bei 90° Phasenverschiebung) und 0,707 (45°).

Das erfindungsgemäße Teilchenstrahlgerät ist vorzugsweise als Elektronenstrahlgerät, insbesondere als TEM, ausgebildet.

Die Erfindung betrifft auch ein Teilchenstrahlgerät mit mindestens einem Objektiv, das eine hintere Brennebene aufweist, sowie mit mindestens einer ersten Beugungslinse zur Abbildung der hinteren Brennebene des Objektivs in eine Beugungs-Zwischenbildebene. Ferner ist mindestens eine zweite Beugungslinse vorgesehen, die in oder im Bereich der Beugungs-Zwischenbildebene angeordnet ist. Auch sind an dem Teilchenstrahlgerät mindestens ein phasenschiebendes Element sowie mindestens ein Mulitpolelement angeordnet, das als Quadrupolelement ausgebildet ist. Das phasenschiebende Element weist vorzugsweise eines der oben genannten Merkmale oder Merkmalskombinationen auf, es ist aber nicht auf diese eingeschränkt Auch bei diesem Teilchenstrahlgerät erfolgt eine Abbildung der Beugungsebene, so daß das phasenschiebende Element entsprechend geometrisch vergrößert ausgestaltet sein kann. Dies gewährleistet zum einen eine einfache Herstellung des phasenschiebenden Elements und zum anderen eine Reduzierung einer Ausblendung von Teilchen eines Teilchenstrahls durch Bauelemente (beispielsweise Haltestege) des phasenschiebenden Elements, wie sie aus dem Stand der Technik bekannt sind.

Nachfolgend wird nun die Erfindung anhand von Ausführungsbeispielen näher erläutert. Dabei zeigen

Fig. 1 eine Draufsicht auf ein erstes phasenschiebendes Element in Form einer Phasenplatte;

Fig. 2 eine geschnittene Ansicht des ersten phasenschiebenden Elements entlang der Linie A-A gemäß Figur 1;

Fig. 3 eine geschnittene Ansicht des ersten phasenschiebenden Elements entlang der Linie B-B gemäß Figur 1;

Fig. 4 eine geschnittene Ansicht eines zweiten phasenschiebenden Elements mit einer Draufsicht gemäß Figur 1, wobei der Schnitt entlang der Linie B-B erfolgt;

Fig. 5a,b schematische Darstellungen von Verteilungen eines inhomogenen Potentials zur Phasenverschiebung;

Fig. 6 eine schematische Darstellung einer mit dem phasenschiebenden Element verbundenen Steuereinheit;

Fig. 7 eine schematische Darstellung einer segmentierten Elektrode;

Fig. 8 eine schematische Darstellung einer kammartigen Anordnung von Elektroden;

Fig. 9 eine Draufsicht auf ein weiteres phasenschiebendes Element;

Fig. 10 eine Draufsicht auf ein weiteres phasenschiebendes Element mit einer kreuzförmigen Öffnung;

Fig. 11 eine schematische Darstellung eines Systems von zwei phasenschiebenden Elementen;

Fig. 12a,b  schematische Darstellungen zweier phasenschiebenden Elemente mit kreuzförmiger Öffnung;

Fig. 13  eine schematische Darstellung eines weiteren phasenschiebenden Elements in einer Drifteinheit-Ausgestaltung;

Fig. 14  eine schematische Darstellung eines oberen Teils eines TEM;

Fig. 15a,b  schematische Darstellungen eines unteren Teils eines TEM mit einem phasenschiebenden Element;

Fig. 16a,b  eine schematische Darstellung eines unteren Teils eines zu den Figuren 15a,b modifizierten TEM mit einem phasenschiebenden Element;

Fig. 17  eine schematische Darstellung eines Strahlenverlaufs in einem unteren Teil eines TEM mit Multipolelementen;

Fig. 18  eine schematische Darstellung eines Strahlenverlaufs in einem unteren Teil eines weiterem TEM mit Multipolelementen;

Fig. 19  eine schematische Darstellung eines unteren Teils eines TEM mit zwei phasenschiebenden Elementen; sowie

Fig. 20  eine schematische Darstellung eines phasenschiebenden Elements mit Kohlenstoff-Filmen.

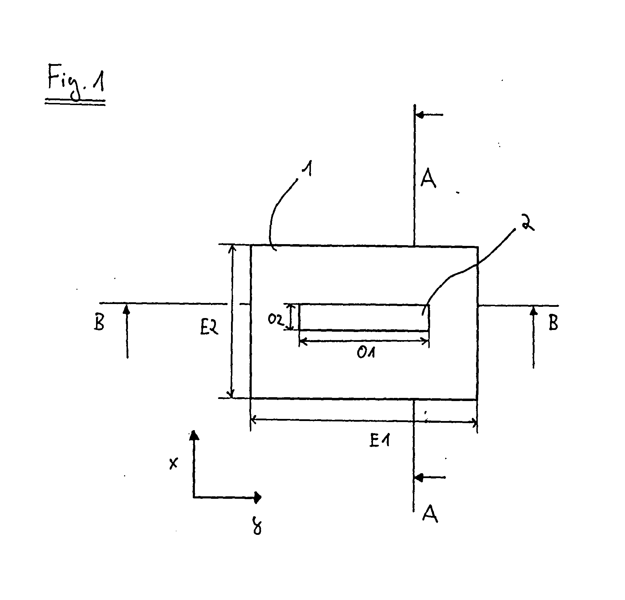

Die Erfindung geht von der Erkenntnis aus, daß mittels eines inhomogenen und/oder anisotropen Potentials, insbesondere eines inhomogenen elektrischen Potentials eine gewünschte Phasenverschiebung mit einfachen geometrischen Ausbildungen erzielbar ist. Figur 1 zeigt eine Draufsicht eines ersten Ausführungsbeispiels eines phasenschiebenden Elements 1 in Form einer Phasenplatte, bei der ein inhomogenes Potential bzw. anisotropes Potential erzeugt wird. Das phasenschiebende Element 1 ist derart im Strahlengang eines Teilchenstrahlgeräts (beispielsweise ein Elektronenstrahlgerät in Form eines TEM) angeordnet, daß die optische Achse des Teilchenstrahlgeräts in z-Richtung verläuft, welche senkrecht zur Blattebene angeordnet ist.

Das phasenschiebende Element 1 weist eine erste Ausdehnung E1 in y-Richtung und eine zweite Ausdehnung E2 in x-Richtung auf. Im Prinzip ist bei diesem Ausführungsbeispiel die Phasenplatte rechteckförmig ausgebildet. Es wird ausdrücklich darauf hingewiesen, daß die Erfindung nicht auf eine rechteckförmige Ausbildung der Phasenplatte eingeschränkt ist. Vielmehr kann die Form der Phasenplatte jede erdenkliche Form aufweisen. Beispielsweise kann sie auch rund ausgebildet sein.

Das phasenschiebende Element 1 ist ungefähr mittig mit einer rechteckförmigen, durchgehenden Öffnung in Form eines Schlitzes 2 versehen. Der Schlitz 2 weist eine erste Ausdehnung O1 in y-Richtung und eine zweite Ausdehnung 02 in x-Richtung auf. Die Ausdehnung O1 beträgt beim dem hier dargestellten Ausführungsbeispiel ungefähr $60\mu m$. Die Ausdehnung 02 beträgt ungefähr $2\mu m$ bis $3\mu m$.

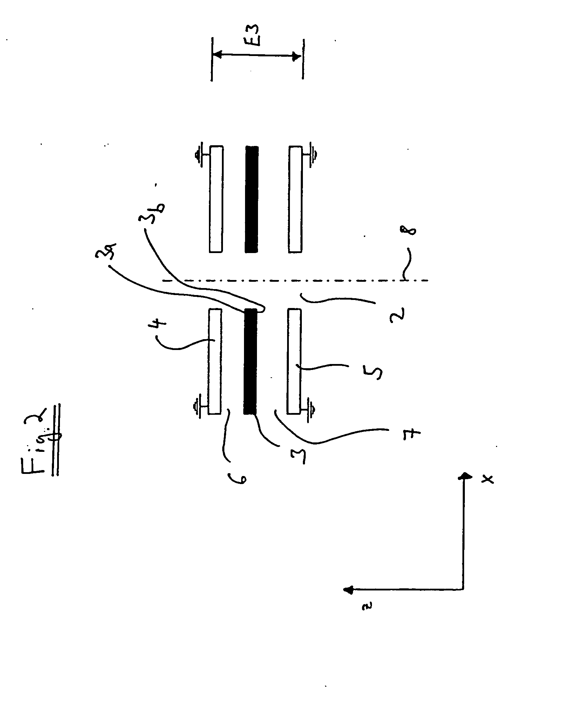

Figur 2 zeigt die schematische Darstellung einer geschnittenen Ansicht des phasenschiebenden Elements 1 entlang der Linie A-A gemäß Figur 1. Das mehrschichtig ausgebildete phasenschiebende Element 1 weist eine dritte Ausdehnung E3 in z-Richtung auf, entlang welcher sich der Schlitz 2 vollständig erstreckt. Das phasenschiebende Element 1 weist ferner eine zentrale Elektrode 3 auf, welche aus Gold gebildet ist und welche mit einer ersten Seite 3a sowie einer zweiten Seite 3b versehen ist. An der ersten Seite 3a ist eine Isolatorschicht 6 angeordnet. Ferner ist an der zweiten Seite 3b eine Isolatorschicht 7 angeordnet. Sowohl die Isolatorschicht 6 als auch die Isolatorschicht 7 sind aus $Al_2O_3$ gebildet. Die Isolatorschicht 6 bzw. 7 ist wiederum mit einer Abschirmschicht 4 bzw. 5 versehen. Sowohl die Abschirmschicht 4 als auch die Abschirmschicht 5 sind aus Gold gebildet und liegen auf dem Potential der Umgebung. Beispielsweise sind sie geerdet.

Eine Achse, welche in Figur 1 in z-Richtung verläuft, ist in Figur 2 mit dem Bezugszeichen 8 versehen. Die Achse verläuft durch den Schlitz 2. Die zentrale Elektrode 3 ist derart mittels einer Elektronikeinheit (Steuereinheit, nicht dargestellt) ansteuerbar, daß im Schlitz 2 ein inhomogenes elektrisches Potential entsteht. Durch den Schlitz 2 treten die gestreuten bzw. ungestreuten Teilchenstrahlen (beispielsweise Elektronenstrahlen in einem TEM) hindurch, wobei der ungestreute Teilchenstrahl (also der Teilchenstrahl nullter Beugungsordnung) zu den Teilchenstrahlen höherer Beugungsordnung eine relative Phasenverschiebung erfährt. Die Interferenz der Teilchenstrahlen höherer Beugungsordnung mit dem phasenverschobenen Teilchenstrahl liefert ein kontrastreiches Bild.

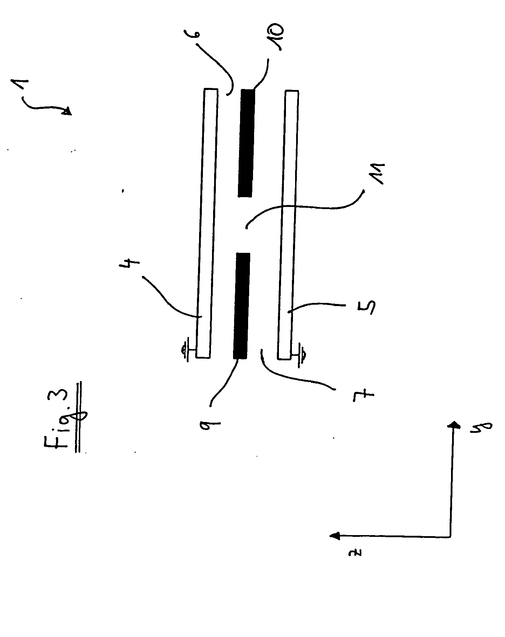

Figur 3 zeigt einen Schnitt entlang der Linie B-B gemäß Figur 1. Die zentrale Elektrode 3 weist wiederum zwei einzeln ansteuerbare Elektroden 9 und 10 auf, die von einer Isolatorschicht 6 und einer Isolatorschicht 7 umgeben sind. Ferner sind die beiden Elektroden 9 und 10 voneinander durch eine Isolatorschicht 11 getrennt. Auch bei diesem Ausführungsbeispiel sind die Isolatorschichten 6, 7 und 11 aus $Al_2O_3$ gebildet. An der Isolatorschicht 6 bzw. 7 ist wiederum eine Abschirmschicht 4 bzw. 5 angeordnet, welche aus Gold gebildet ist und auf dem Potential der Umgebung liegt (beispielsweise geerdet ist).

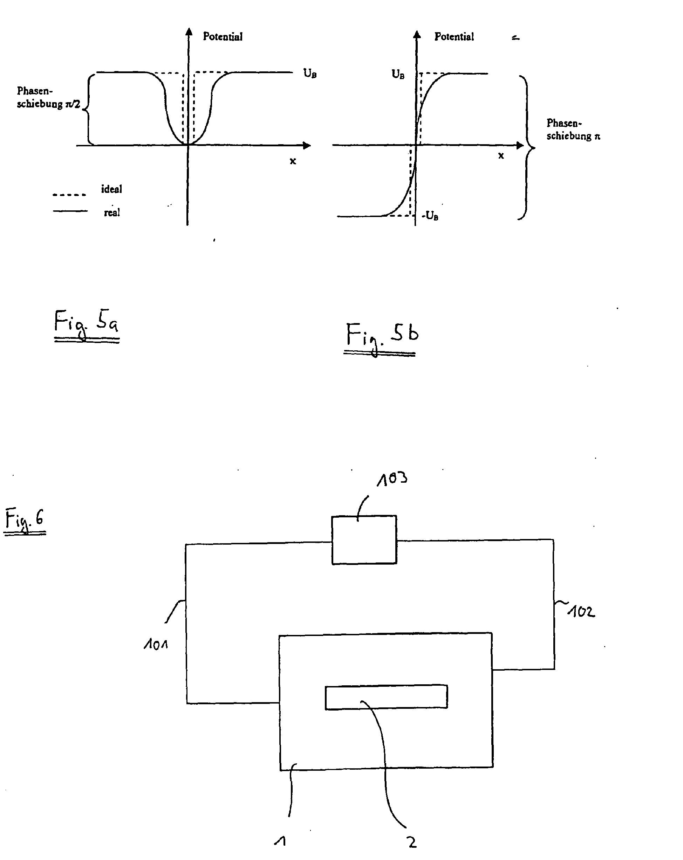

Über eine Elektronikeinheit (Steuereinheit, nicht dargestellt) wird an der Elektrode 9 ein erstes Potential ($-U_B$) erzeugt, während an der Elektrode 10 ein zweites Potential ($U_B$) erzeugt wird. Der Potentialverlauf ist in Figur 5b wiedergegeben. Wie zu erkennen ist, erfährt ein durch den Schlitz 2 tretender ungebeugter Teilchenstrahl zu den gebeugten Teilchenstrahlen höherer Beugungsordnung, die durch den Schlitz 2 treten, eine relative Phasenverschiebung von 180° (also π). Das in Figur 3 dargestellte Ausführungsbeispiel dient der Phasenverschiebung nach Hilbert und ist somit als Hilbert-Phasenplatte ausgebildet.

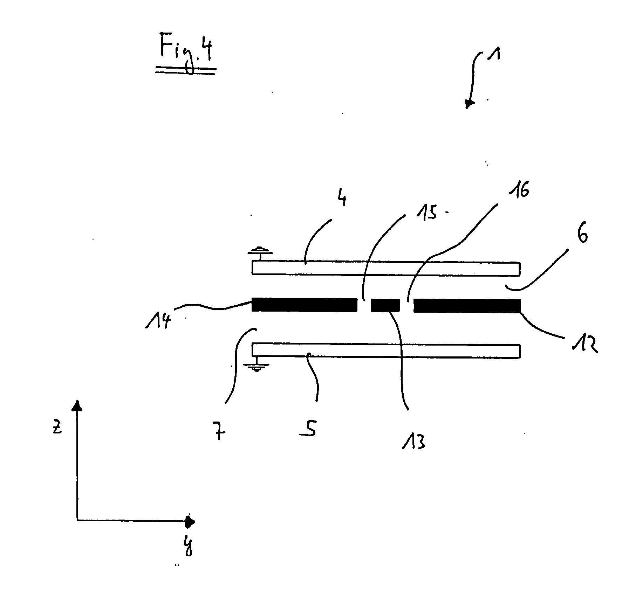

Figur 4 zeigt ein weiteres Ausführungsbeispiel eines erfindungsgemäßen mehrschichtigen phasenschiebenden Elements 1 in Form einer Phasenplatte. Gleiche Bezugszeichen werden für gleiche Elemente wie bei den zuvor beschriebenen Ausführungsbeispielen verwendet. Auch dieses phasenschiebende Element 1 weist in der Draufsicht denselben Aufbau wie das in den Figuren 1 und 2 dargestellte Ausführungsbeispiel auf. Demnach weist es auch den Schlitz 2 auf. Betrachtet man aber das weitere Ausführungsbeispiel in einer Schnittdarstellung entlang der Linie B-B, so erkennt man den etwas zum Ausführungsbeispiel gemäß Figur 3 unterschiedlichen Aufbau. Bei dem Ausführungsbeispiel gemäß Figur 4 ist die Elektrode 3 aus drei aus Gold gebildeten Elektroden 12, 13 und 14 gebildet, die voneinander mittels Isolatorschichten 15 und 16 aus $Al_2O_3$ getrennt sind. Alternativ hierzu sind die Isolatorschichten durch Vakuum gebildet. An den Seiten der Elektroden 12 bis 14 sind weitere, aus $Al_2O_3$ gebildete Isolatorschichten 6 und 7 angeordnet, die wiederum mit aus Gold gebildeten und auf dem Potential der Umgebung liegenden (beispielsweise geerdeten) Abschirmschichten 4 und 5 versehen sind.

Über eine Elektronikeinheit (Steuereinheit, nicht dargestellt) werden wieder Potentiale derart erzeugt, daß an den Elektroden 12 und 14 jeweils ein Potential $U_B$ anliegt, während an der Elektrode 13 ein Potential $U_0$ anliegt. Der Potentialverlauf ist in Figur 5a wiedergegeben. Wie zu erkennen ist, erfährt ein durch den Schlitz 2 tretender ungebeugter Teilchenstrahl eine zu gebeugten Teilchenstrahlen höherer Beugungsordnung, die durch den Schlitz 2 treten, relative Phasenverschiebung von 90° (also π/2). Das in Figur 4 dargestellte Ausführungsbeispiel dient der Phasenverschiebung nach Zernike und ist somit als Zernike-Phasenplatte ausgebildet.

Figur 6 zeigt die Anordnung des phasenschiebenden Elements 1 nach den Figuren 1,2, 3 und 4 und eine Steuereinheit 103, die über Leitungen 101 und 102 mit dem phasenschiebenden Element 1 verbunden sind. Mittels der Steuereinheit 103 sind die obengenannten Elektroden einzeln zur Erzeugung des gewünschten Potentials ansteuerbar.

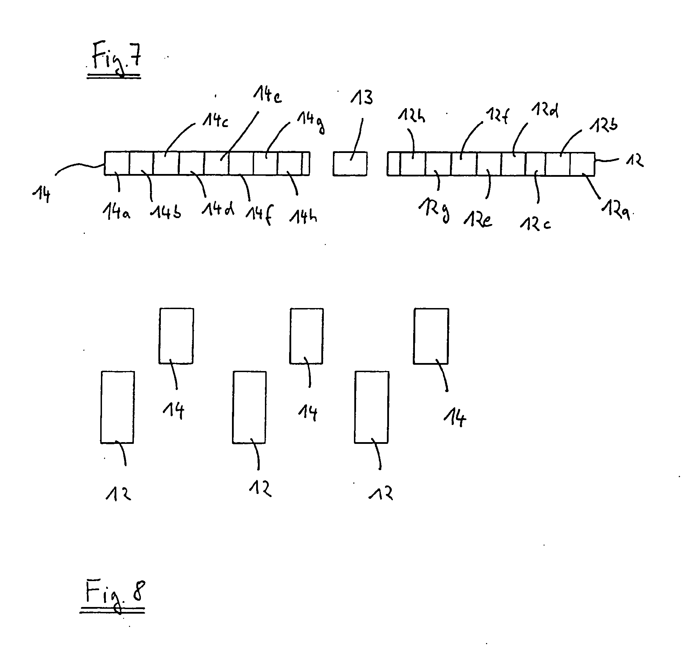

Figuren 7 und 8 zeigen weitere Ausgestaltungen von Elektroden, die an dem erfindungsgemäßen phasenschiebenden Element 1 verwirklicht sein können. Figur 7 zeigt eine zentrale Elektrode 13 sowie zwei hierzu durch Isolatoren beabstandete Elektroden 12 und 14, welche jeweils segmentiert sind. So weist die Elektrode 12 gegeneinander isolierte Segmente 12a bis 12h auf, während die Elektrode 14 gegeneinander isolierte Segmente 14a bis 14h aufweist. Jedes einzelne Segment ist einzeln ansteuerbar. Sie sind im Grunde wie in Figur 6 jeweils mit der Steuereinheit 103 verbunden.

Eine weitere Ausgestaltung der Elektroden zeigt Figur 8. Bei dieser Ausgestaltung sind die Elektroden 12 und 14 kammartig angeordnet.

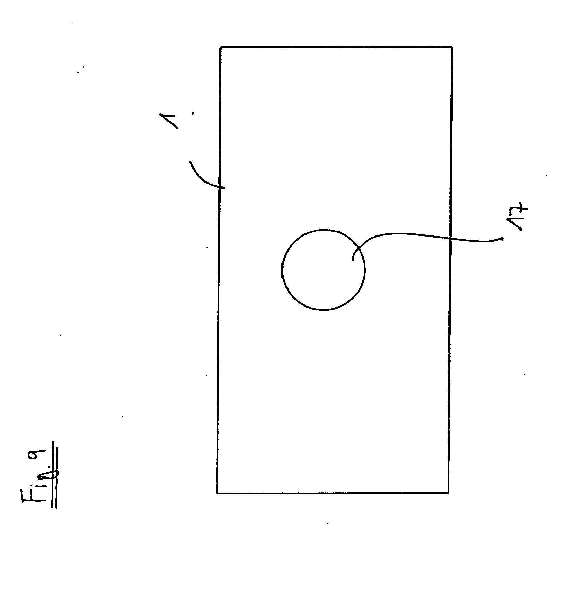

Figur 9 zeigt ein weiteres Ausführungsbeispiel eines erfindungsgemäßen phasenschiebenden Elements 1 mit einer kreisförmigen Öffnung 17.

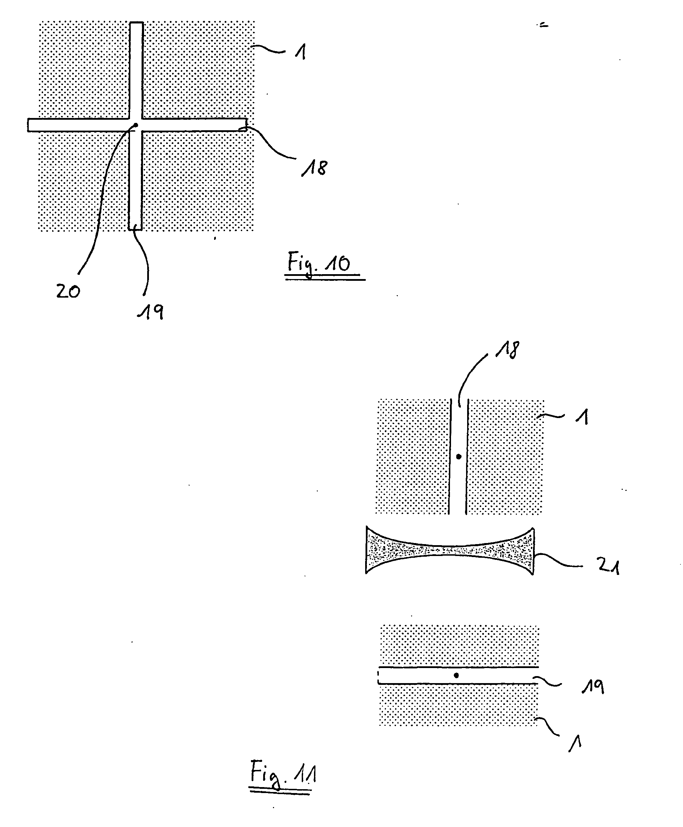

Figur 10 zeigt ein weiteres Ausführungsbeispiel eines phasenschiebenden Elements 1. Dieses ist mit zwei rechteckförmigen Schlitzen 18 und 19 versehen, welche unter einem rechten Winkel zueinander angeordnet sind. Die beiden Schlitze 18 und 19 bilden somit ein Kreuz, in dessen Zentrum 20 der nichtgebeugte Teilchenstrahl hindurchtritt. Der mehrschichtige Aufbau dieses phasenschiebenden Elements 1 entspricht im Prinzip dem Aufbau gemäß der Figuren 3 oder 4. Auch diese Ausführungsform gewährleistet die Bereitstellung eines inhomogenen elektrischen Potentials, so daß der nichtgebeugte Teilchenstrahl zu den Teilchenstrahlen höherer Beugungsordnung eine relative Phasenverschiebung aufgeprägt erhält. Aufgrund der kreuzförmigen Ausbildung wird ein gekreuzter Phasenkontrast erzeugt.

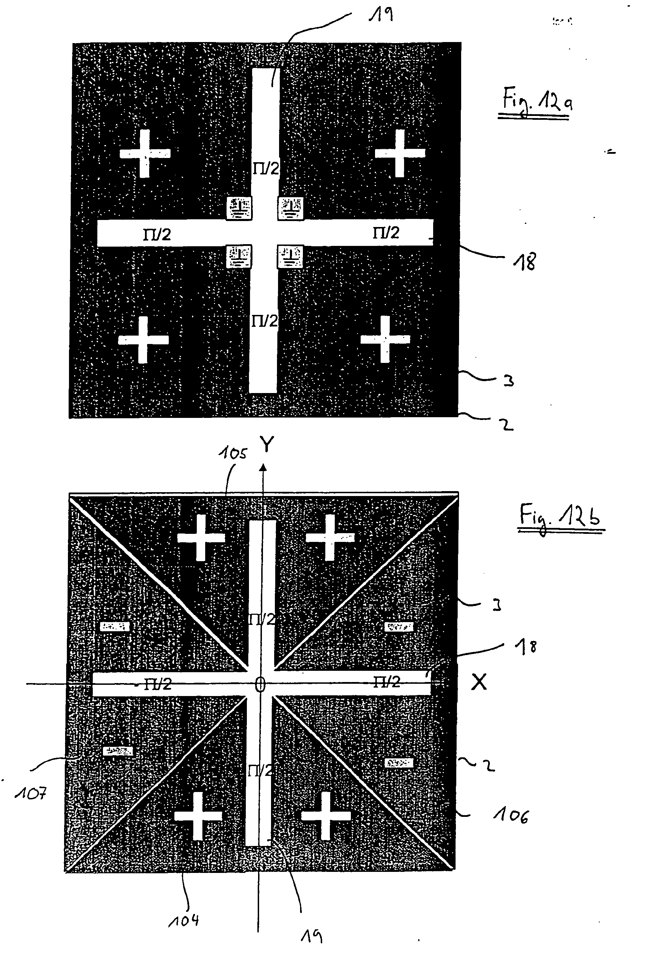

Figur 12a zeigt eine weitere Darstellung einer Phasenplatte 2 mit den beiden kreuzförmigen Schlitzen 18 und 19. Dargestellt ist nur die Elektrode 3 (Mittelelektrode), welche auf positivem Potential liegt. Zur Erzeugung eines Nullpotentials auf der optischen Achse liegen die 4 inneren Quadranten jeweils auf Masse bzw. sind mit einer leicht negativen Spannung beaufschlagt. In den Schlitzen 18 und 19 wird jeweils ein Potential für eine relative Phasenverschiebung von π/2 erzeugt.

Figur 12b zeigt eine weitere Darstellung einer Phasenplatte mit kreuzförmig angeordneten Schlitzen 18 und 19. Bei diesem Ausführungsbeispiel liegen die Elektroden 104 und 105 auf positivem Potential, während die Elektroden 106 und 107 auf negativem Potential liegen. In den Schlitzen 18 und 19 wird wiederum ein Potential für eine relative Phasenverschiebung erzeugt. Das Potential im X-Schnitt erzeugt eine relative Phasenverschiebung von - π/2, während das Potential im Y-Schnitt eine relative Phasenverschiebung von π/2 erzeugt. Da das Potential im X-Schnitt im Fernbereich negativ ist und im Y-Schnitt im Fernbereich positiv ist, wird ein Nulldurchgang des Potentials auf der optischen Achse erzielt.

Eine gute Erzeugung eines inhomogenen elektrischen Potentials und die Gewährleistung einer ausreichend guten Phasenverschiebung werden auch durch eine Ausgestaltung bereitgestellt, welche in Figur 11 schematisch dargestellt ist. Bei diesem Ausführungsbeispiel werden zwei phasenschiebende Elemente 1 in Form von Phasenplatten verwendet, die jeweils eine schlitzförmige Öffnung 18 bzw. 19 aufweisen. Die beiden phasenschiebenden Elemente 1 sind in einem Teilchenstrahlgerät (beispielsweise ein TEM) hintereinander geschaltet, wobei zwischen den beiden phasenschiebenden Elementen 1 eine Quadrupoloptik 21 angeordnet ist. Die beiden phasenschiebenden Elemente 1 sind dabei derart zueinander angeordnet, daß die beiden schlitzförmigen Öffnungen 18 und 19 senkrecht zueinander angeordnet sind. Beide phasenschiebende Elemente 1 stellen ein inhomogenes elektrisches Potential derart zur Verfügung, daß nach Durchlaufen eines Teilchenstrahls durch die Öffnungen 18 und 19 der nichtgebeugte Anteil des Teilchenstrahls relativ zum gebeugten Anteil des Teilchenstrahls eine Phasenverschiebung erfährt, wobei durch die Hintereinanderschaltung der beiden phasenschiebenden Elemente 1 wiederum ein gekreuzter Phasenkontrast erzeugt wird.

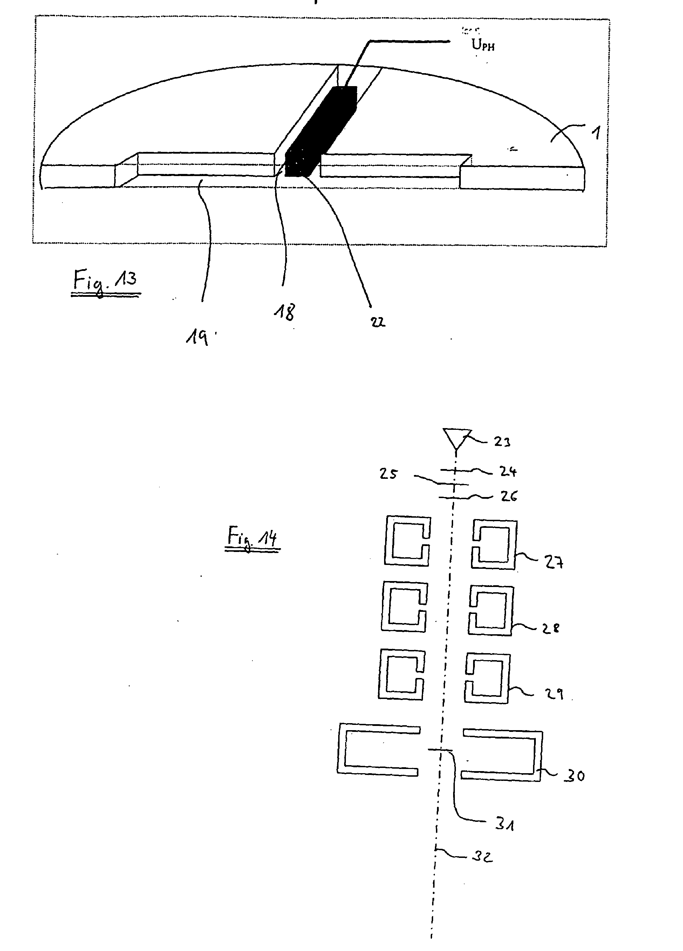

Figur 13 zeigt ein weiteres Ausführungsbeispiel eines phasenschiebenden Elements 1 in Form einer Phasenplatte. Figur 13 ist eine schematische Ansicht einer Hälfte des phasenschiebenden Elements 1, wobei diese wiederum mit schlitzförmigen Öffnungen 18 und 19 versehen ist, welche kreuzförmig angeordnet sind. In der Öffnung 18 ist eine Elektrode, die mit einer gegenüberliegenden Elektrode (nicht dargestellt) eine Drifteinheit 22 bildet, angeordnet, welche von einer Isolationsschicht aus Vakuum oder $Al_2O_3$ umgeben ist. Die Drifteinheit 22 ist zur Bereitstellung eines inhomogenen elektrischen Potentials ausgebildet und bedingt daher ebenfalls, daß der gebeugte Teilchenstrahl hinsichtlich des ungebeugten Teilchenstrahls eine relative Phasenverschiebung erfährt.

Figur 14 zeigt den oberen Teil eines TEM, dessen unterer Teil weiter unten näher beschrieben wird. Das TEM weist eine Elektronenquelle 23 in Form einer thermischen Feldemissionsquelle auf. Allerdings ist durchaus auch eine andere Elektronenquelle verwendbar. Entlang der optischen Achse 32 des TEM ist hinter die Elektronenquelle 23 eine Extraktionselektrode 24 angeordnet, durch deren Potential Elektronen aus der Elektronenquelle 23 abgesaugt werden. Ferner ist eine Elektrode 25 zur Fokussierung der Quellenlage sowie mindestens eine weitere Elektrode 26 zur Beschleunigung vorgesehen. Aufgrund der Elektrode 26 werden die aus der Elektronenquelle 23 austretenden Elektronen mittels einer Elektrodenspannung auf eine gewünschte und einstellbare Energie beschleunigt. Ein derartiger Aufbau ist bereits seit langem bekannt und wird daher hier nicht weiter im Einzelnen diskutiert.

Im weiteren Verlauf auf der optischen Achse 32 ist ein mehrstufiger Kondensor angeordnet, der drei Magnetlinsen 27 bis 29 aufweist, und an den sich ein Objektiv 30 anschließt. Am Objektiv 30 ist eine Objektebene 31 angeordnet, an der eine zu untersuchende Probe mittels eines Probenmanipulators angeordnet werden kann. Es erfolgt eine Fokussierung der Elektronenquelle in die hintere Brennebene des Objektivs 30.

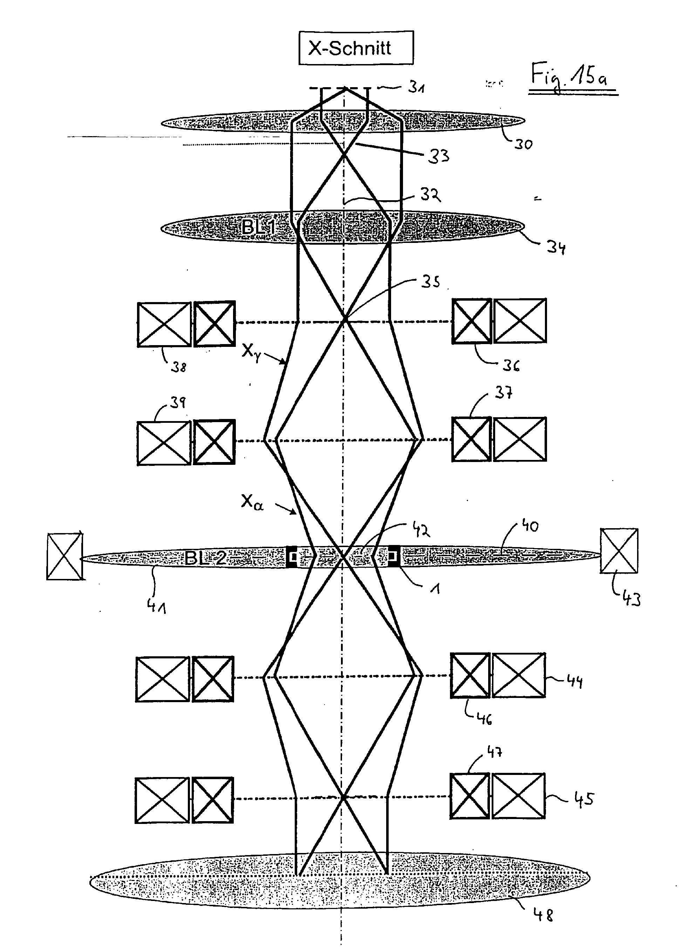

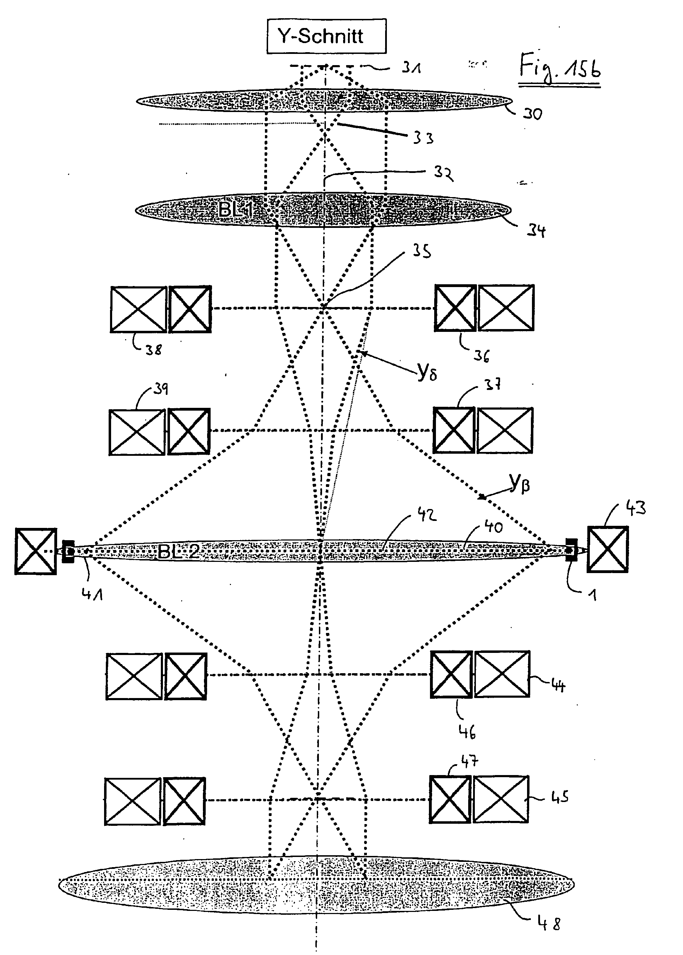

Figuren 15a und 15b zeigen den unteren Teil des TEM, welches ein System zur anamorphotischen Abbildung einer Beugungsebene mit einem Multipolsystem aufweist. Dabei zeigen Figur 15a den X-Schnitt (also den Schnitt entlang der X-Achse) sowie Figur 15b den Y-Schnitt (also den Schnitt entlang der Y-Achse). An das Objektiv 30 gemäß Figur 14 schließt sich entlang der optischen Achse 32 des TEM eine erste Beugungslinse 34 an. Daran anschließend sind ein erstes Quadrupolelement 36 sowie ein zweites Quadrupolelement 37 angeordnet. Zu Justierzwecken ist dem Quadrupolelement 36 ein Ablenksystem 38 zugeordnet, während dem Quadrupolelement 37 ein Ablenksystem 39 zugeordnet ist. Beide Ablenksysteme 38 und 39 weisen ein Dipolfeld auf. In der Beugungs-Zwischenbildebene 40 ist eine zweite Beugungslinse 41 angeordnet, wobei die Hauptebene der zweiten Beugungslinse 41 der Beugungs-Zwischenbildebene 40 entspricht. In der Hauptebene der zweiten Beugungslinse 41 ist auch das phasenschiebende Element 1 angeordnet, welches bei dem hier dargestellten Ausführungsbeispiel eines der bereits oben diskutierten phasenschiebenden Elemente 1 ist. Beispielsweise ist es das phasenschiebende Element 1 nach den Figuren 1, 2 und 3. Im Bereich der Hauptebene der zweiten Beugungslinse 41 ist auch ein Quadrupolelement 43 angeordnet. Im weiteren Verlauf der optischen Achse 32 sind weitere Quadrupolelemente vorgesehen. So folgen der zweiten Beugungslinse 41 ein Quadrupolelement 46 und ein Quadrupolelement 47. Beiden Quadrupolelementen 46 und 47 ist jeweils wieder ein Ablenksystem 44 bzw. 45 zugeordnet, welches wiederum jeweils ein Dipolfeld aufweist. An das Quadrupolelement 47 schließt sich entlang der optischen Achse 32 dann eine Projektivlinse 48 an.

Nachfolgend wird die Funktionsweise des TEM gemäß den Figuren 14, 15a und 15b näher beschrieben. Anamorphotische Abbildungen, wie sie bei dem hier dargestellten TEM erzeugt werden, lassen sich durch eine Multipolanordnungen bewirken, welche durch 4 Fundamentalbahnen beschrieben werden können. Es sind dies die Bahnen $x_\alpha$, $y_\beta$, $x_\gamma$ sowie $y_\delta$. Die Fundamentalbahn, die in der Abbildungsebene (also der Objektebene 31) auf der optischen Achse 32 im X-Schnitt beginnt (Abbildungsstrahlen), werden mit $x_\alpha$ bezeichnet. Der entsprechende Y-Schnitt wird mit $y_\beta$ bezeichnet. Die Fundamentalbahn, die unter einem bestimmten Winkel in der Beugungsebene 33, welcher der hinteren Brennebene des Objektivs 30 entspricht, beginnt (Feldstrahlen), wird im X-Schnitt mit $x_\gamma$ und im Y-Schnitt mit $y_\delta$ bezeichnet. Die Bahnen genügen den Gleichungen des Wechselsatzes:

$$x'_\alpha \bullet x_\gamma - x_\alpha \bullet x'_\gamma = 1$$

$$y'_\beta \bullet y_\delta - y_\beta \bullet y'_\delta = 1$$

wobei die gestrichenen Größen jeweils für die Ableitungen (Steigungen) der Bahnen stehen. Der Wechselsatz ist bereits seit langem bekannt, so daß hierauf nicht näher eingegangen wird.

Das zu untersuchende Objekt liegt im Brennpunkt des Objektivs 30, so daß ein paralleles Bündel der Abbildungsstrahlen das Objektiv 30 verläßt. Mittels der ersten Beugungslinse 34 wird das Bündel der Abbildungsstrahlen in das erste Zwischenbild 35 fokussiert. Die vordere (objektseitige) Brennebene der ersten Beugungslinse 34 liegt in der hinteren Brennebene bzw. Beugungsebene 33 des Objektivs 30, so daß die Feldstrahlen die erste Beugungslinse 34 parallel verlassen. Das Quadrupolelement 36 ist derart im Bereich des Zwischenbildes 35 angeordnet, daß es die Abbildungsstrahlen nicht beeinflußt. Jedoch werden durch das erste Quadrupolelement 36 die Feldstrahlen defokussiert ($x_\gamma$) bzw. fokussiert ($y_\delta$). In Verbindung mit dem weiteren Quadrupolelement 37 entsteht ein fokussiertes, stigmatisches Bild der Beugungsebene 33. Die Abbildungsstrahlen werden durch das Quadrupolelement 36 nicht beeinflusst, jedoch werden sie von dem Quadrupolelement 37 beeinflußt, denn sie werden in eine Richtung (nämlich $y_\beta$) defokussiert und in die hierzu senkrechte Richtung ($x_\alpha$) fokussiert. Auf diese Weise entsteht in der Beugungs-Zwischenbildebene 40 (welche eine Symmetrieebene ist) ein Beugungsbild der Beugungsebene 33 mit unterschiedlicher Vergrößerung in den beiden Bildschnitten X und Y. Man erhält somit ein anamorphotisches (also linear-verzeichnetes) Beugungsbild. Mit der Bedingung für eine fokussierte Beugungsabbildung

$$x_\gamma(ZS) = y_\delta(ZS) = 0 ,$$

wobei ZS der Beugungs-Zwischenbildebene 40 entspricht, müssen die Bahnen und Steigungen der Bahnen den folgenden Gleichungen genügen.

$$x_\alpha(ZS) \bullet x'_\gamma(ZS) = -1$$

$$y_\beta(ZS) \bullet y'_\delta(ZS) = -1$$

Das Verhältnis von $y_\beta$ und $x_\alpha$ in der Beugungs-Zwischenbildebene 40 (ZS) ist das Aspektverhältnis, welches bei dem hier dargestellten Ausführungsbeispiel im Bereich von 1:10 bis 1:100 liegt. Das Aspektverhältnis definiert die Dimensionen des phasenschiebenden Elements 1, welches rechteckförmig mit dem Schlitz 2 ausgebildet ist. Die Dimension des Schlitzes 2 ist dabei derart gewählt, daß das Beugungsbild der hinteren Brennebene 33 zumindest teilweise oder auch vollständig durch den Schlitz 2 geführt wird. Mit anderen Worten ausgedrückt, wird der ungestreute bzw. ungebeugte Teilchenstrahl nullter Ordnung zusammen mit zumindest einigen gestreuten bzw. gebeugten Teilchenstrahlen höherer Beugungsordnungen durch den Schlitz 2 geführt.

Die Verwendung der Kombination des phasenschiebenden Elements 1 mit der anamorphotischen Abbildung weist den Vorteil auf, daß keine störenden Halteeinrichtungen für das phasenschiebende Element 1 mehr benötigt werden. Somit wird bei der Erfindung im Unterschied zum Stand der Technik kein Teil eines Teilchenstrahls durch Abschattung ausgeblendet. Man erhält somit ein gutes Signal und demnach eine gute Bildinformation. Zudem gewährleistet die Verwendung eines inhomogenen Potentials, daß der erhaltene Phasenkontrast raumfrequenzunabgängig bleibt.

Im weiteren Verlauf des Strahlengangs des TEM wird die anamorphotische Abbildung wieder kompensiert. Hierzu dienen die Quadrupolelemente 43, 46 und 47. Die zweite Beugungslinse 41 und die Quadrupolelemente 43, 44 und 45 beeinflußen die Abbildungsstrahlen $x_\alpha$ und $y_\beta$ derart, daß sie spiegelsymmetrisch zur anamorphotischen Beugungsebene verlaufen, jedoch treten die Feldstrahlen, welche in der Symmetrieebene fokussiert sind, unbeeinflusst durch die Symmetrieebene. Die Feldstrahlen $x_\gamma$ und $y_\delta$ verlaufen dagegen antisymmetrisch zur Ebene des phasenschiebenden Elements 1. Aufgrund der vorliegenden Symmetrieeigenschaften kompensieren die unterhalb der Beugungs-Zwischenbildebene 40 angeordneten Quadrupolelemente 46 und 47, denen wieder durch die Ablenksysteme 44 und 45 ein Dipolfeld überlagert ist, die Anamorphie des Strahlengangs.

Statt des phasenschiebenden Elements 1, welches eine Ausgestaltung nach den Figuren 1, 2 und 3 aufweist, kann auch ein phasenschiebendes Element 1 mit einer kreuzförmigen Öffnung (beispielsweise Figur 10) in der Beugungs-Zwischenbildebene 40 angeordnet werden. Durch geeignete Schaltung der Quadrupolelemente ist es möglich, daß die anormophotische Abbildung der Beugungsebene 33 um 90° gedreht werden kann. Somit können auch die gebeugten Teilstrahlen, die senkrecht zum Spalt verlaufen, nachfolgend in der Phase geschoben werden.

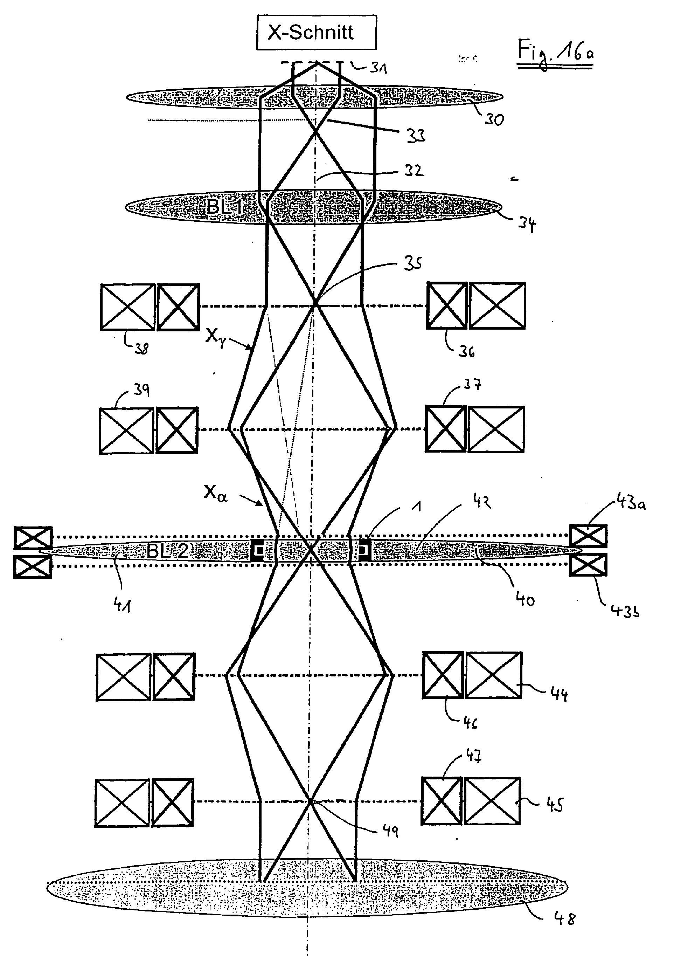

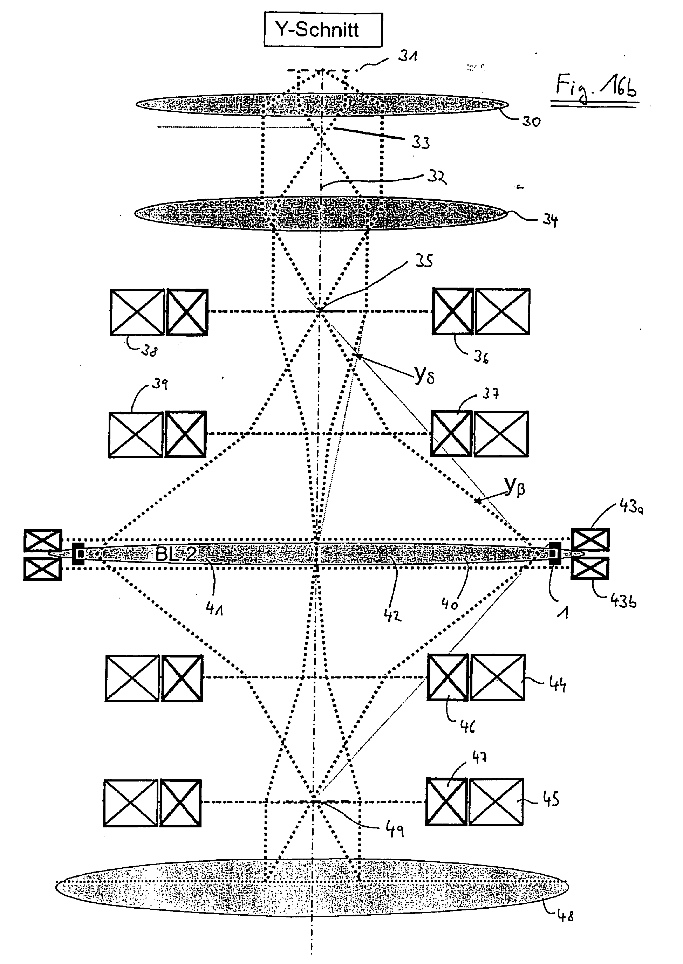

Figuren 16a und 16b zeigen einen zu den Figuren 15a und 15b nahezu identischen unteren Teil eines TEM, das allerdings im Unterschied im Bereich der Beugungs-Zwischenbildebene 40 mit einem UnterMultipolelement in Form eines Quadrupolements 43a und einem UnterMultipolelement in Form eines Quadrupolelements 43b versehen ist. Die Aufspaltung des in den Figuren 15a und 15b dargestellten Quadrupolelements 43 in zwei Quadrupolelemente 43a und 43b ist aus Montagegründen von Vorteil, da es hierdurch erleichtert wird, das phasenschiebende Element 1 mit Manipulatoren im Strahlengang des TEM anzuordnen. Die Funktion der Quadrupolelemente 43a und 43b wird nachfolgend erläutert.

Das Quadrupolelement 43a bewirkt, daß der Abbildungsstrahl $y_\beta$ leicht fokussiert und der Abbildungsstrahl $x_\alpha$ leicht defokussiert wird, so daß diese eine gemeinsame virtuelle Abbildungsebene haben, welche im Zwischenbild 35 liegt. Diese Abbildungsebene wird von der zweiten Beugungslinse 41 in die Zwischenbildebene 49 abgebildet. Das Quadrupolelement 43b wirkt entsprechend analog zum Quadrupolelement 43a und bewirkt eine entsprechende Fokussierung bzw. Defokussierung der Abbildungsstrahlen.

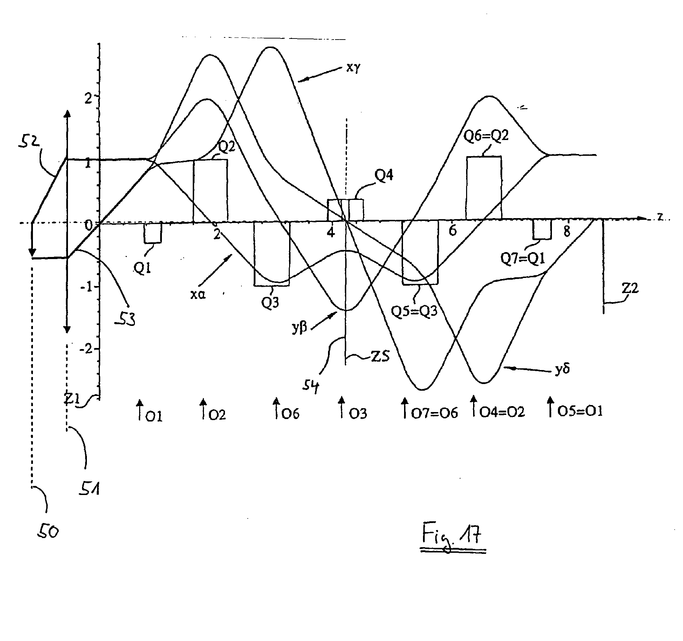

Figur 17 zeigt ein weiteres Ausführungsbeispiel eines Abbildungssystems in einem TEM, welches im Grunde drei Dinge miteinander vereint, nämlich ein phasenschiebendes Element, eine anamorphotische Abbildung einer Beugungsebene sowie eine Farb- und Fehlerkorrektur.

Das Objektiv bzw. die Objektebene ist bei diesem Ausführungsbeispiel mit dem Bezugszeichen 50 in Figur 17 versehen, während die hintere Brennebene bzw. die Beugungsebene des Objektivs 50 mit dem Bezugszeichen 51 bezeichnet ist. Ferner sind im Strahlengang entlang der in z-Richtung ausgerichteten optischen Achse des TEM zahlreiche Multipolelemente in Form von Quadrupolen und Oktupolen angeordnet. Die Figur 17 zeigt im Grunde den Verlauf und die Stärken der entlang der optischen Achse z angeordneten Quadrupole bzw. deren Quadrupolfelder Q1 bis Q7. Die Quadrupole Q1 bis Q7 sind symmetrisch zur mittleren Symmetrieebene ZS angeordnet, welche gleichzeitig die Beugungs-Zwischenbildebene ist und in welcher ein phasenschiebendes Element 54 angeordnet ist. Das phasenschiebende Element 54 weist einen Aufbau gemäß den Figuren 1, 2 und 3 auf.

Die Symmetrieebene ZS ist dabei eine Symmetrieebene sowohl hinsichtlich der Quadrupolfelder als auch hinsichtlich der Fundamentalbahnen. Die Quadrupole Q1 bis Q7 sind elektrisch-magnetisch ausgebildet. Sie bestehen demnach aus einer Überlagerung von zueinander elektrostatischen und magnetischen Quadrupolfeldern. Die Abbildungsbahnen 52, also die Bahnen, die in der Objektebene 50 unter einem bestimmten Winkel beginnen und mit $x_\alpha$ und $y_\beta$ bezeichnet sind, verlaufen symmetrisch zur Symmetrieachse ZS. Die Feldbahnen 53, also die Bahnen, die unter einem bestimmten Winkel in der Beugungsebene 51 starten und mit $x_\gamma$ und $y_\delta$ bezeichnet werden, verlaufen zur Symmetrieachse ZS antisymmetrisch. In der Symmetrieebene ZS wird die hintere Beugungsebene 51 anamorphotisch, also linearverzeichnet abgebildet, wie es im Grunde bereits für die Ausführungsbeispiele gemäß den Figuren 15a,b und 16a,b beschrieben wurde.

Das Ausführungsbeispiel gemäß Figur 17 weist zudem fünf Oktupole O1 bis 05 auf. Die Oktupole O1 bis 05 sind mit entsprechenden Pfeilen gekennzeichnet. Die Lagen der einzelnen Oktupole O1 bis 05 entlang der optischen Achse z sind in Bezug auf den Verlauf der Fundamentbahnen derart gewählt, daß sich Komponenten des Öffnungsfehlers des Objektivs korrigieren lassen. Ein Oktupolpaar ist an Stellen angeordnet, an denen der Strahl weitgehende Rotationssymmetrie hat, wie in Bereichen vor dem ersten Quadrupol Q1 und hinter dem letzten Quadrupol Q7. Weitere Oktupolpaare 02, 03 und 04 sind in Bereichen astigmatischer Zwischenbilder angeordnet, also den Nulldurchgängen der Fundamentalbahnen, da hierdurch eine weitgehende Entkopplung der Fehlerkorrektur gewährleistet ist. Anstelle eines Oktupols 03 in der Symmetrieebene ZS können auch zwei Oktupole 06 un 07 dem dritten bzw. fünften Oktupol überlagert sein.

Das nun in Figur 17 beschriebene Ausführungsbeispiel kombiniert vorteilhaft drei wesentliche Aspekte, nämlich die Verwendung eines phasenschiebenden Elements 54, die anamorphotische Abbildung der Beugungsebene sowie die Farb- und Fehlerkorrektur mittels eines Multipolsystems. Es weist somit zusätzlich zu den bereits oben genannten Vorteilen und Wirkungsweisen noch die Farb- und Fehlerkorrektur auf. Diese kann aber auch entfallen, so daß das vorbeschriebene Multipolsystem ausschließlich zur anamorphotischen Abbildung verwendet wird, wobei das Aspektverhältnis sich bei diesem Ausführungsbeispiel besonders gut einstellen läßt.

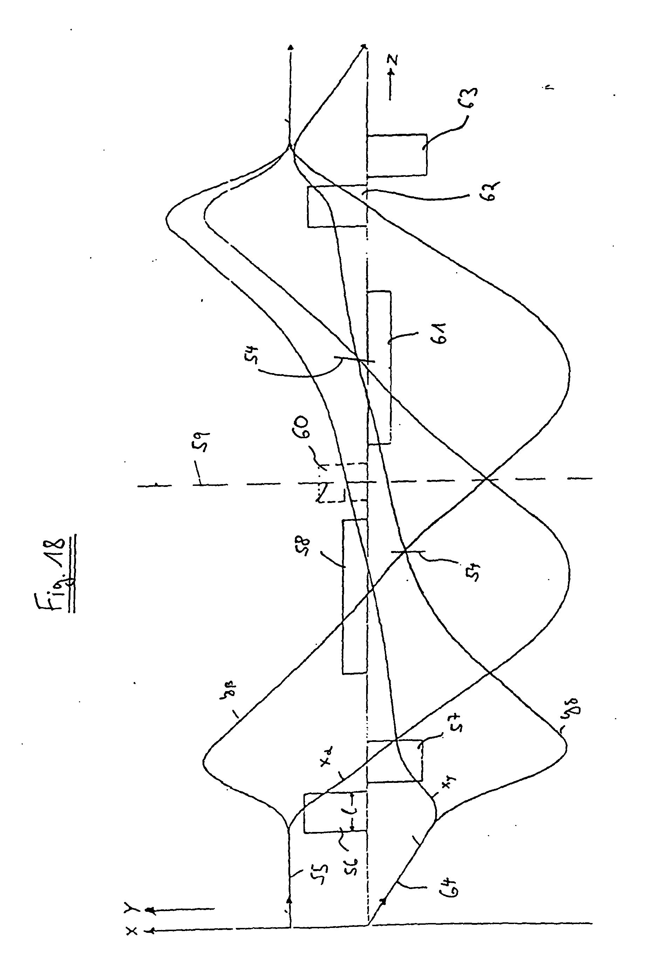

Ein weiteres Ausführungsbeispiel eines TEM, das ein phasenschiebendes Element, eine anamorphotische Abbildung der Beugungsebene des Objektivs des TEM und eine Farb- und Fehlerkorrektur aufweist, ist in Figur 18 schematisch dargestellt. Mit z ist wiederum die optische Achse des TEM bezeichnet. Die beiden senkrecht zueinander verlaufenden Schnitte in x- und in y-Richtung sind senkrecht aufeinander projeziert.

Mit $x_\alpha$ bzw. $y_\beta$ ist die x-Komponente bzw. die y-Komponente des von der Achse eines Objektpunktes ausgehenden axialen Strahls 55 bezeichnet (die weiteren Fundamentalbahnen sind wiederum mit $x_\gamma$ und $y_\delta$ bezeichnet). Die beiden Komponenten werden in einem ersten Quadrupol 56 unterschiedlich abgelenkt. Hierbei entsteht ein astigmatisches Zwischenbild, wobei die im X-Schnitt verlaufende Bahn zu Null wird und demnach die optische Achse z schneidet. An dieser Stelle ist ein weiterer Quadrupol 57 angeordnet, der aufgrund seiner Position nur die $y_\beta$-Komponente beeinflußt und die $x_\alpha$-Komponente unbeeinflußt läßt. Ein weiterer Quadrupol 58 befindet sich am nächsten zu dem Ort, an dem die $y_\beta$-Komponente die optische Achse z schneidet. An diesem Ort findet dann nur eine Beeinflussung der $x_\alpha$-Komponente in Form einer Umkehrung statt.

Ferner ist ein Oktupol 60 vorgesehen, welcher symmetrisch zur Symmetrieebene 59 angeordnet ist. Darüberhinaus sind weitere Oktupole vorgesehen, die bei dieser Darstellung nicht eingezeichnet sind.

Das dargestellte Ausführungsbeispiel weist zwar einen symmetrischen Aufbau in Bezug auf die Anordnung der Multipole (Symmetrieebene 59) auf. Jedoch haben die Quadrupole 61 bis 63 gegenüber den Quadrupolen 56 bis 58 eine entgegengesetzte Polarität. Obwohl der Strahlverlauf asymmetrisch ist, läßt sich auch hier eine rechteckförmige Phasenplatte anordnen.

Wie oben erwähnt, weist der außeraxiale Strahl 64 ebenfalls zwei Komponenten auf, nämlich die $x_\gamma$-Komponente und die $y_\delta$-Komponente. Diese werden gleichermaßen durch den ersten Quadrupol 56 aufgespalten sowie durch den Quadrupol 57 abgelenkt.

Auch bei diesem Ausführungsbeispiel ist ein phasenschiebendes Element 54 gemäß den Figuren 1, 2 und 3 vorgesehen. Dabei kann dieses an zwei unterschiedlichen Orten angeordnet werden. Auch hier wird die hintere Brennebene bzw. Beugungsebene des Objektivs in der Symmetrieebene 59 anamorphotisch abgebildet, so daß dieselben Vorteile - wie bereits oben beschrieben - erzielt werden. Besonders von Vorteil ist die Anordnung des phasenschiebenden Elements 54 im Bereich des Quadrupols 61. Hier ergibt sich ein recht großes Aspektverhältnis. Die $x_\gamma$- Komponente verläuft zwar weit entfernt von der Achse z (senkrecht zu einer phasenschiebenden Richtung), jedoch wird mit einem phasenschiebenden Element 54 mit kreuzförmig ausgestalteter Öffnung der stark astigmatische ungebeugte Teilchenstrahl (Nullstrahl) durchgelassen, ohne daß er eine Phasenverschiebung erfährt. Die gebeugten Teilchenstrahlen höherer Ordnung erfahren jedoch eine Phasenverschiebung.

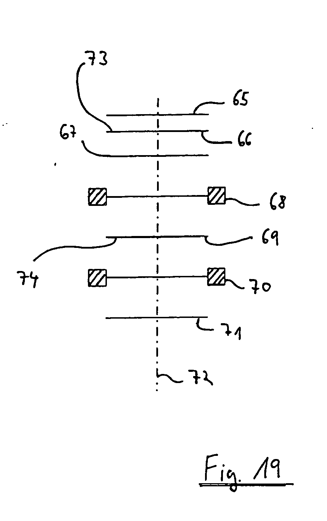

Figur 19 zeigt eine schematische Darstellung eines weiteren Ausführungsbeispiels eines unteren Teils eines TEM. So sind entlang einer optischen Achse 72 des TEM das Objektiv 65 angeordnet, welches eine hintere Brennebene bzw. Beugungsebene 66 aufweist. In der hinteren Brennebene bzw. Beugungsebene 66 ist auch ein erstes phasenschiebendes Element 73 angeordnet, welches gemäß den Figuren 1, 2 und 3 ausgestaltet ist. Weiter ist im Strahlengang des TEM entlang der optischen Achse 72 eine erste Beugungslinse 67 angeordnet, an der sich weiter im Strahlengang des TEM ein Quadrupolelement 68 anschließt. Die erste Beugungslinse 67 weist eine Bildebene auf, welche zum eine die Beugungs-Zwischenbildebene und zum anderen die konjugierte Ebene zur Beugungsebene 66 des Objektivs 65 ist. In der Beugungs-Zwischenbildebene ist mit ihrer Hauptebene eine zweite Beugungslinse 69 angeordnet. In dieser Beugungs-Zwischenbildebene ist auch ein zweites phasenschiebendes Element 74 angeordnet, welches ebenfalls gemäß dem Ausführungsbeispiel der Figuren 1, 2 und 3 ausgestaltet sind. Hinter der zweiten Beugungslinse 69 ist ein weiteres Quadrupolelement angeordnet, an denen sich eine Projektivlinse 71 anschließt. Auch bei diesem Ausführungsbeispiel wird mittels der ersten Beugungslinse 67 eine vergrößerte Abbildung der hinteren Brennebene 66 des Objektivs 65 in der Beugungs-Zwischenbildebene 69 bereitgestellt, so daß auch hier die bereits oben genannten Vorteile erzielt werden.

An dieser Stelle wird ausdrücklich darauf hingewiesen, daß die in den Figuren 14 bis 19 beschriebenen Ausführungsformen nicht auf die Verwendung des in den Figuren 1, 2 und 3 dargestellten Ausführungsbeispiels des phasenschiebenden Elements eingeschränkt ist. Vielmehr ist jedes phasenschiebende Element verwendbar, mit dem ein inhomogenes oder anisotropes Potential zur Phasenverschiebung erzeugbar ist.

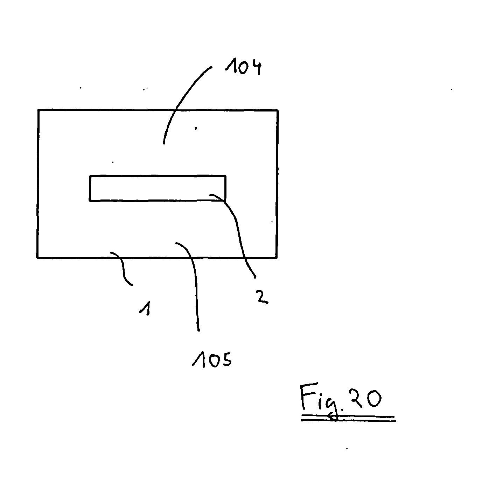

Figur 20 zeigt eine Kombination des phasenschiebenden Elements 1 gemäß der Erfindung mit zwei seitlich angeordneten Kohlestoff-Filmen 104 und 105. Diese Ausführungsform kombiniert den Stand der Technik mit dem erfindungsgemäßen phasenschiebenden Element 1.

Die Erfindung wurde anhand eines TEM, also eines Transmissionselektronenmikroskops beispielhaft beschrieben. Es wird aber ausdrücklich darauf hingewiesen, daß die Erfindung nicht auf Transmissionselektronenmikroskope eingeschränkt ist. Vielmehr ist die Erfindung bei jedem Teilchenstrahlgerät verwendbar, bei welchem der Einsatz eines phasenschiebenden Elements gewünscht ist, beispielsweise auch ein Transmissionsionenmikroskop.

**Bezugszeichenliste**

| | |
|---|---|
| 1 | phasenschiebendes Element |
| 2 | Schlitz |
| 3 | zentrale Elektrode |
| 3a | erste Seite |
| 3b | zweite Seite |
| 4 | Abschirmschicht |
| 5 | Abschirmschicht |
| 6 | Isolatorschicht |
| 7 | Isolatorschicht |
| 8 | Achse |
| 9 | Elektrode |
| 10 | Elektrode |
| 11 | Isolatorschicht |
| 12 | Elektrode |
| 12a bis 12h | Elektrode |
| 13 | Elektrode |
| 14 | Elektrode |
| 14a bis 14h | Elektrode |
| 15 | Isolatorschicht |
| 16 | Isolatorschicht |
| 17 | Öffnung |
| 18 | Schlitz |
| 19 | Schlitz |
| 20 | Strahl nullter Ordnung |
| 21 | Quadrupoloptik |
| 22 | Drifteinheit |
| 23 | Elektronenquelle |
| 24 | Extraktionselektrode |
| 25 | Elektrode |
| 26 | Elektrode |
| 27 | Magnetlinse (Kondensor) |
| 28 | Magnetlinse (Kondensor) |
| 29 | Magnetlinse (Kondensor) |
| 30 | Objektiv |
| 31 | Objektivebene |
| 32 | optische Achse |
| 33 | Beugungsebene |
| 34 | erste Beugungslinse |
| 35 | Zwischenbild |

| 36 | Quadrupolelement |
| 37 | Quadrupolelement |
| 38 | Doppelabkenkeinheit |
| 39 | Doppelablenkeinheit |
| 40 | Zwischenbildebene |
| 41 | zweite Beugungslinse |
| 42 | anamorphotisches Beugungsbild |
| 43 | Quadrupolelement |
| 44 | Doppelablenkeinheit |
| 45 | Doppelablenkeinheit |
| 46 | Quadrupolelement |
| 47 | Quadrupolelement |
| 48 | Projektivlinse |
| 49 | Zwischenbild |
| 50 | Objektiv |
| 51 | Beugungsebene |
| 52 | Strahl |
| 53 | Strahl |
| 54 | phasenschiebendes Element |
| 55 | axialer Strahl |
| 56 | Quadrupolelement |
| 57 | Quadrupolelement |
| 58 | Quadrupolelement |
| 59 | Symmetrieebene |
| 60 | Oktupol |
| 61 | Quadrupolelement |
| 62 | Quadrupolelement |
| 63 | Quadrupolelement |
| 64 | außeraxialer Strahl |
| 65 | Objektiv |
| 66 | Beugungsebene |
| 67 | Beugungslinse |
| 68 | Quadrupolelement |
| 69 | Beugungs-Zwischenbildebene |
| 70 | Quadrupolelement |
| 71 | Projektivlinse |
| 72 | optische Achse |
| 73 | phasenschiebendes Element |
| 74 | phasenschiebendes Element |
| | |
| 101 | Leitung |
| 102 | Leitung |
| 103 | Steuereinheit |
| 104 | Kohlenstoff-Film |
| 105 | Kohlenstoff-Film |
| | |
| Z1 | erstes Zwischenbild |
| ZS | Symmetrieebene mit anamorphotischen Beugungsbild |
| Q1-Q7 | Quadrupolelemente |
| O1-O6 | Oktupolelemente |

## Patentansprüche

1. Phasenschiebendes Element (1, 54, 73, 74) zum Schieben der Phase zumindest eines Teiles eines Teilchenstrahls, mit mindestens einem Mittel (2, 17, 18, 19) zur Erzeugung eines inhomogenen Potentials (U$_B$),
**dadurch gekennzeichnet, dass** an dem phasenschiebenden Element (1,54, 73, 74) zur Erzeugung des inhomogenen Potentials eine Öffnung in zu einer Ebene des phasenschiebenden Elements (1, 54, 73, 74) senkrechter Richtung nicht rotationssymmetrisch ausgebildet ist.

2. Phasenschiebendes Element (1, 54, 73, 74) zum Schieben der Phase zumindest eines Teiles eines Teilchenstrahls, insbesondere nach Anspruch 1, mit mindestens einem Mittel (2, 17, 18, 19) zur Erzeugung eines anisotropen Potentials (U$_B$),
**dadurch gekennzeichnet, dass** an dem phasenschiebenden Element (1, 54, 73, 74) zur Erzeugung des anisotropen Potentials eine Öffnung in zu einer Ebene des phasenschiebenden Elements (1, 54, 73, 74) senkrechter Richtung nicht rotationssymmetrisch ausgebildet ist.

3. Phasenschiebendes Element (1, 54, 73, 74) nach Anspruch 1 oder 2 , wobei das Mittel (2, 17, 18, 19) zur Erzeugung eines inhomogenen Potentials zur Erzeugung eines elektrischen Potentials (U$_B$) ausgebildet ist.

4. Phasenschiebendes Element (1, 54, 73, 74) nach einem der vorangehenden Ansprüche, wobei das Mittel zur Erzeugung eines inhomogenen Potentials zur Erzeugung eines magnetischen Potentials ausgebildet ist.

5. Phasenschiebendes Element (1, 54, 73, 74) nach einem der vorangehenden Ansprüche , wobei das phasenschiebende Element (1, 54, 73, 74) mehrere Öff. nungen (2, 17, 19, 19) aufweist.

6. Phasenschiebendes Element (1, 54, 73, 74) nach einem der Ansprüche 1 bis 4 , wobei das phasenschiebende Element (1, 54, 73, 74) genau eine Öffnung (2, 17, 18, 19) aufweist.

7. Phasenschiebendes Element (1, 54, 73, 74) nach Anspruch 5 oder 6, wobei

   - das phasenschiebende Element (1) eine erste Element-Ausdehnung (E1) entlang einer ersten Achse (y) und eine zweite Element-Ausdehnung (E2) entlang einer zweiten Achse (x) aufweist,
   - die erste Achse (y) nicht parallel zu der zweiten Achse (x) angeordnet ist, und wobei
   - sich die Öffnung (2) sowohl entlang der ersten Achse (y) als auch entlang der zweiten Achse (x) erstreckt.

8. Phasenschiebendes Element (1) nach Anspruch 7, wobei die Öffnung (2) eine erste Öffnungsausdehnung (O1) entlang der ersten Achse (y) und eine zweite Öffnungsausdehnung (O2) entlang der zweiten Achse (x) aufweist, wobei die erste Öffnungsausdehnung (O1) größer als die zweite Öffnungsausdehnung (02) ist.

9. Phasenschiebendes Element (1) nach Anspruch 7 oder 8, wobei die erste Achse (y) senkrecht zur zweiten Achse (x) angeordnet ist,

10. Phasenschiebendes Element (1) nach einem der Ansprüche 7 bis 9, wobei das phasenschiebende Element (1) eine dritte Achse (z) aufweist, die nicht parallel sowohl zur ersten Achse (y) als auch zur zweiten Achse (x) verläuft, und entlang derer sich eine dritte Öffnungsausdehnung (E3) erstreckt.

11. Phasenschiebendes Element (1) nach einem der vorangehenden Ansprüche, wobei die Öffnung (2, 18, 19) schlitzförmig ausgebildet ist.

12. Phasenschiebendes Element (1) nach einem der vorangehenden Ansprüche, wobei die Öffnung (2, 18, 19) rechteckförmig ausgebildet ist.

13. Phasenschiebendes Element (1) nach einem der vorangehenden Ansprüche, wobei die Öffnung (18, 19) kreuzförmig ausgebildet ist.

14. Phasenschiebendes Element (1) nach einem der vorangehenden Ansprüche, wobei das phasenschiebende Element (1) mehrschichtig ausgebildet ist.

15. Phasenschiebendes Element (1) nach einem der vorangehenden Ansprüche, wobei das phasenschiebende Element (1) mindestens eine Elektrode (3, 9, 10, 12, 13, 14) aufweist.

16. Phasenschiebendes Element (1) nach Anspruch 15, wobei die Elektrode (12a bis 12h, 14a bis 14h) segmentiert ist.

17. Phasenschiebendes Element (1) nach Anspruch 15 oder 16, wobei in einer Ebene eine erste Elektrode (12) und eine zweite Elektrode (14) vorgesehen sind, die einzeln ansteuerbar und mit unterschiedlichen Potentialen einzeln beaufschlagbar sind.

18. Phasenschiebendes Element (1) nach einem der Ansprüche 15 bis 17, wobei die Elektrode (3, 9, 10, 12, 13, 14) oder mindestens eine der ersten Elektrode (12) und der zweiten Elektrode (14) eine erste Seite (3a) und eine zweite Seite (3b) aufweist und wobei an der ersten Seite (3a) ein erster Isolator (6) angeordnet ist.

19. Phasenschiebendes Element (1) nach Anspruch 18, wobei an der zweiten Seite (3b) ein zweiter Isolator (7) angeordnet ist.

20. Phasenschiebendes Element (1) nach Anspruch 18 oder 19, wobei an dem ersten Isolator (6) eine erste Abschirmeinheit (4) angeordnet ist.

21. Phasenschiebendes Element (1) nach Anspruch 19 oder 20, wobei an dem zweiten Isolator (7) eine zweite Abschirmeinheit (5) angeordnet ist.

22. Phasenschiebendes Element (1) nach einem der vorangehenden Ansprüche, wobei das phasenschiebende Element (1) eine Drifteinheit (22) aufweist.

23. Phasenschiebendes Element (1) nach einem der vorangehenden Ansprüche, wobei das phasenschiebende Element (1) mindestens einen Abschnitt (104, 105) mit einem inneren Potential aufweist.

24. System mit mindestens einem ersten phasenschiebenden Element (1, 73, 74) und mit mindestens einem zweiten phasenschiebenden Element (1, 73, 74), wobei sowohl das erste phasenschiebende Element (1, 73, 74) als auch das zweite phasenschiebende Element (1, 73, 74) nach einem der vorangehenden Ansprüche ausgebildet sind.

25. System nach Anspruch 24, wobei

- das System eine optische Achse (72) aufweist,
- das erste phasenschiebende Element (1, 73, 74) und das zweite phasenschiebende Element (1, 73, 74) entlang der optischen Achse (72) angeordnet sind, und wobei
- das zweite phasenschiebende Element (1, 74) hinter dem ersten phasenschiebenden Element (1, 73) angeordnet ist.

26. Teilchenstrahlgerät mit

- mindestens einem Objektiv (30, 50, 65), das eine hintere Brennebene (33, 51, 66) aufweist,
- mindestens einer ersten Beugungslinse (34, 67) zur vergrößerten Abbildung der hinteren Brennebene (33, 53, 66) des Objektivs (30, 50, 65) in eine Beugungs-Zwischenbildebene (40, 59, 69, ZS)
- mindestens einer zweiten Beugungslinse (41, 69), die in der Beugungs-Zwischenbildebene (40, 69) angeordnet ist,
- mindestens einem Multipolelement (36, 37, 43, 46, 47, 56 bis 58, 61 bis 63, Q1 bis Q7), sowie mit
- mindestens einem phasenschiebenden Element (1) nach einem der Ansprüche 1 bis 23.

27. Teilchenstrahlgerät nach Anspruch 26, wobei das Teilchenstrahlgerät eine optische Achse (32, z) aufweist und wobei vom Objektiv (30, 50, 65) in Richtung der zweiten Beugungslinse (41, 69) das mindestens eine Multipolelement (36, 37, 43, 46, 47, 56 bis 58, 61 bis 63, Q1 bis Q7) angeordnet ist.

28. Teilchenstrahlgerät nach Anspruch 27, wobei

    - das Teilchenstrahlgerät ein erstes Multipolelement (36) und ein zweites Multipolelement (37) aufweist, und wobei
    - vom Objektiv (30) aus in Richtung der zweiten Beugungslinse (41) die erste Beugungslinse (34), das erste Mulitpolelement (36), das zweite Multipolelement (37) und die Beugungs-Zwischenbildebene (40) angeordnet sind.

29. Teilchenstrahlgerät nach Anspruch 28, wobei das Teilchenstrahlgerät ein drittes Multipolelement (46), ein viertes Multipolelement (47) sowie eine Projektivlinse (48) aufweist, wobei von der zweiten Beugungslinse (41) in Richtung der Projektivlinse (48) das dritte Mulitipolelement (46), das vierte Mulitpoelement (47) und die Projektivlinse (48) angeordnet sind.

30. Teilchenstrahlgerät nach Anspruch 29, wobei ein fünfte Multipolelement (43) im Bereich der Beugungs-Zwischenbildebene (40) angeordnet ist.

31. Teilchenstrahlgerät nach Anspruch 30, wobei das fünfte Multipolelement (43) ein erstes Untermulitpolelement (43a) und ein zweites Untermultipolelement (43b) aufweist.

32. Teilchenstrahlgerät nach einem der Ansprüche 26 bis 31, wobei das Multipolelement mindestens einen magnetischen oder elektrischen Pol aufweist.

33. Teilchenstrahlgerät nach einem der Ansprüche 26 bis 32, wobei das Multipolelement (36, 37, 43, 46, 47, 56 bis 58, 61 bis 63, Q1 bis Q7) oder mindestens eines der Multipolelemente (36, 37, 43, 46, 47, 56 bis 58, 61 bis 63, Q1 bis Q7) ein Quadrupolfeld erzeugt.

34. Teilchenstrahlgerät nach Anspruch 33, wobei das Multipolelement als Quadrupolelement (36, 37, 43, 46, 47, 56 bis 58, 61 bis 63, Q1 bis Q7) ausgebildet ist.

35. Teilchenstrahlgerät nach einem der Ansprüche 26 bis 34, wobei dem Multipolelement (36, 37, 46, 47) ein Doppelablenksystem (38, 39, 44, 45) mit einem Dipolfeld zugeordnet ist.

36. Teilchenstrahlgerät nach einem der Ansprüche 26 bis 35, wobei das Teilchenstrahlgerät mindestens sechs Quadrupolelemente (56, 57, 58, 61, 62, 63) aufweist, die antisymmetrisch zu der Beugungs-Zwischenbildebene (59) erregbar sind, wobei jedem der sechs Quadrupolelemente (56, 57, 58, 61, 62, 63) und der Beugungs-Zwischenbildebene (59) jeweils ein Oktupol (60) überlagert ist.

37. Teilchenstrahlgerät nach einem der Ansprüche 26 bis 35, mit

    - mindestens einem sechs Quadrupolelemente (Q1 bis Q7) enthaltenden Quadrupol-Septuplet, wobei die Quadrupolelemente (Q1 bis Q7) symmetrisch zu der Beugungs-Zwischenbildebene (ZS) erregbar sind, sowie mit
    - mindestens fünf innerhalb des Quadrupol-Septuplet erregbaren Oktupolen (O1 bis O7).

38. Teilchenstrahlgerät nach Anspruch 36 oder 37, wobei mindestens einer der Oktupole (60, O1 bis O7) elektrisch oder magnetisch ausgebildet ist.

39. Teilchenstrahlgerät nach einem der Ansprüche 26 bis 38, wobei das Teilchenstrahlgerät mit einem Korrektor zur Korrektur von Aberrationen versehen ist.

40. Teilchenstrahlgerät nach einem der Ansprüche 26 bis 39, wobei das Teilchenstrahlgerät als Elektronenstrahlgerät, insbesondere als Transmissionselektronenmikroskop, ausgebildet ist.

**Claims**

1. A phase-shifting element (1, 54, 73, 74) for shifting the phase of at least a portion of a particle beam, having at least one means (2, 17, 18, 19) for generating a non-homogeneous potential ($U_B$), **characterlzed In that** a non-rotationally symmetric opening is formed on the phase-shifting element (1, 54, 73, 74) in the perpendicular direction to a plane of the phase-shifting element (1, 54, 73, 74) for generating the non-homogeneous potential.

2. Phase-shifting element (1, 54, 73, 74) for shifting the phase of at least a portion of a particle beam, in particular according to claim 1, having at least one means (2, 17, 18, 19) for generating an anisotropic potential ($U_g$)), **characterized In that** a non-rotationally symmetric opening Is formed on the phase-shifting element (1, 54, 73, 74) in the perpendicular direction to a plane of the phase-shifting element (1, 54, 73, 74) for generating the anisotropic potential.

3. Phase-shifting element (1, 54, 73, 74) according to claim 1 or 2, wherein the means (2, 17, 18, 19) for generating a non-homogeneous potential is designed for generating an electric potential ($U_B$).

**4.** Phase-shifting element (1, 54, 73, 74) according to one of the preceding claims, wherein the means for generating a non-homogeneous potential Is designed for generating a magnetic potential,

**5.** Phase-shifting element (1, 54, 73, 74) according to one of the preceding claims, wherein the phase-shifting element (1, 54, 73, 74) has a plurality of openings (2, 17, 18, 19).

**6.** Phase-shifting element (1, 54, 73, 74) according to one of claims 1 through 4, wherein the phase-shifting element (1, 54, 73, 74) has exactly one opening (2, 17, 18, 19).

**7.** Phase-shifting element (1, 54, 73, 74) according to claim 5 or 6, wherein

    - the phase-shifting element (1) has a first element dimension (E1) along a first axis (y) and a second element dimension (E2) along a second axis (x),
    - the first axis (y) is not parallel to the second axis (x), and wherein
    - the opening (2) extends both along the first axis (y) and along the second axis (x).

**8.** Phase-shifting element (1) according to claim 7, wherein the opening (2) has a first opening dimension (01) along the first axis (y) and a second opening dimension (02) along the second axis (x), the first opening dimension (01) being greater than the second opening dimension (02).

**9.** Phase-shifting element (1) according to claim 7 or 8, wherein the first axis (y) is situated perpendicular to the second axis (x).

**10.** Phase-shifting element (1) according to one of claims 7 through 9, wherein the phase-shifting element (1) has a third axis (z), which Is not parallel either to the first axis (y) or the second axis (x) and along which there extends a third opening dimension (E3).

**11.** Phase-shifting element (1) according to one of the preceding claims, wherein the opening (2, 18, 19) has a slot-shaped design.

**12.** Phase-shifting element (1) according to one of the preceding claims, wherein the opening (2, 18, 19) has a rectangular design.

**13.** Phase-shifting element (1) according to one of the preceding claims, wherein the opening (18, 19) has a cross-shaped design.

**14.** Phase-shifting element (1) according to one of the preceding claims, wherein the phase-shifting element (1) has a multilayer design.

**15.** Phase-shifting element (1) according to one of the preceding claims, wherein the phase-shifting element (1) has at least one electrode (3, 9, 10, 12, 13, 14).

**16.** Phase-shifting element (1) according to claim 15, wherein the electrode (12a through 12h, 14a through 14h) is segmented.

**17.** Phase-shifting element (1) according to claim 15 or 16, wherein a first electrode (12) and a second electrode (14), which are individually controllable and to which different potentials may be individually applied, are provided In one plane.

**18.** Phase-shifting element (1) according to one of claims 15 through 17, wherein the electrode (3, 9. 10, 12, 13, 14) or at least one of the first electrode (12) and the second electrode (14) has a first side (3a) and a second side (3b) and wherein a first insulator (6) Is situated on the first side (3a).

**19.** Phase-shifting element (1) according to claim 18, wherein a second Insulator (7) is situated on the second side (3b).

**20.** Phase-shifting element (1) according to claim 18 or 19, wherein a first shield unit (4) is situated on the first insulator (6).

**21.** Phase-shifting element (1) according to claim 19 or 20, wherein a second shield unit (5) is situated on the second insulator (7).

**22.** Phase-shifting element (1) according to one of the preceding claims, wherein the phase-shifting element (1) has a drift unit (22).

**23.** Phase-shifting element (1) according to one of the preceding claims, wherein the phase-shifting element (1) has at least one section (104, 105) having an internal potential.

**24.** A system having at least one first phase-shifting element (1, 73, 74) and at least one second phase-shifting element (1, 73, 74), both the first phase-shifting element (1, 73, 74) and the second phase-shifting element (1, 73, 74) being designed according to one of the preceding claims.

**25.** The system according to claim 24, wherein

    - the system has an optical axis (72),
    - the first phase-shifting element (1, 73, 74) and the second phase-shifting element (1, 73, 74) are situated along the optical axis (72), and wherein
- the second phase-shifting element (1, 74) is situated downstream from the first phase-shifting element (1, 73).

26. A particle beam device having

- at least one objective (30, 50, 65) which has a back focal plane (33, 51, 66),
- at least one first diffraction lens (34, 67) for enlarged Imaging of the back focal plane (33, 53, 66) of the objective (30, 50, 65) In an intermediate diffraction pattern plane (40, 59, 69, ZS),
- at least one second diffraction lens (41, 69) which is situated In the intermediate diffraction pattern plane (40, 69),
- at least one multipole element (36, 37, 43, 46, 47, 56 through 58, 61 through 63, Q1 through Q7), and having
- at least one phase-shifting element (1) according to one of claims 1 through 23.

27. Particle beam device according to claim 26, wherein the particle beam device has an optical axis (32, z) and wherein the at least one multipole element (36, 37, 43, 46, 47, 56 through 58, 61 through 63, Q1 through Q7) Is situated In the direction of the second diffraction lens (41, 69) from the objective (30, 50, 65).

28. Particle beam device according to claim 27, wherein

- the particle beam device has a first multipole element (36) and a second multipole element (37), and
- the first diffraction lens (34), the first multipole element (36), the second multipole element (37), and the intermediate diffraction pattern plane (40) are situated in the direction of the second diffraction lens (41) from the objective (30).

29. Particle beam device according to claim 28, wherein the particle beam device has a third multipole element (46), a fourth multipole element (47) and a projective lens (48), the third multipole element (46), the fourth multipole element (47), and the projective lens (48) being situated In the direction of the projective lens (48) from the second diffraction lens (41).

30. Particle beam device according to claim 29, wherein a fifth multipole element (43) is situated in the area of the intermediate diffraction pattern plane (40).

31. Particle beam device according to claim 30, wherein the fifth multipole element (43) has a first submultipole element (43a) and a second submultipole element (43b).

32. Particle beam device according to one of claims 26 through 31, wherein the multipole element has at least one magnetic or electric pole.

33. Particle beam device according to one of claims 26 through 32, wherein the multipole element (36, 37, 43, 46, 47, 56 through 58, 61 through 63, Q1 through Q7) or at least one of the multipole elements (36, 37, 43, 46, 47, 56 through 58, 61 through 63, Q1 through Q7) generates a quadrupole field.

34. Particle beam device according to claim 33, wherein the multipole element Is designed as a quadrupole element (36, 37, 43, 46, 47, 56 through 58, 61 through 63, Q1 through Q7).

35. Particle beam device according to one of claims 26 through 34, wherein a double deflector system (38, 39, 44, 45) having a dipole field Is associated with the multipole element (36, 37, 46, 47).

36. Particle beam device according to one of claims 26 through 35, wherein the particle beam device has at least six quadrupole elements (56, 57, 58, 61, 62, 63), which are excitable antisymmetrically to the intermediate diffraction pattern plane (59), an octupole (60) being superimposed on each of the six quadrupole elements (56, 57, 58, 61, 62, 63) and on the intermediate diffraction pattern plane (59).

37. Particle beam device according to one of claims 26 through 35, having

- a quadrupole septuplet containing at least six quadrupole elements (Q1 through Q7), the quadrupole elements (Q1 through Q7) being excitable symmetrically to the intermediate diffraction pattern plane (ZS), and having
- at least five octupoles (O1 through 07) excitable within the quadrupole septuplet.

38. Particle beam device according to claim 36 or 37, wherein at least one of the octupoles (60, 01 through 07) has an electric or magnetic design.

39. Particle beam device according to one of claims 26 through 38, wherein the particle beam device is provided with a corrector for correcting aberrations.

40. Particle beam device according to one of claims 26 through 39, wherein the particle beam device is designed as an electron beam device, In particular as a transmission electron microscope.

**Revendications**

1. Elément déphaseur (1, 54, 73, 74) pour un déphasage de la phase d'au mois une partie d'un faisceau de particules, avec au moins un moyen (2, 17, 18, 19) de génération d'un potentiel inhomogène ($U_B$), **caractérisé en ce qu'**une ouverture est réalisée de manière exempte de symétrie de révolution dans une direction perpendiculaire à un plan de l'élément déphaseur (1, 54, 73, 74) pour une génération du potentiel inhomogène au niveau de l'élément déphaseur (1, 54, 73, 74).

2. Elément déphaseur (1, 54, 73, 74) pour le déphasage de la phase d'au moins une partie d'un faisceau de particules, en particulier selon la revendication 1, avec au moins un moyen (2, 17, 18, 19) de génération d'un potentiel anisotrope ($U_B$), **caractérisé en ce qu'**une ouverture est réalisée de manière exempte de symétrie de révolution dans une direction perpendiculaire à un plan de l'élément déphaseur (1, 54, 73, 74) pour générer le potentiel anisotrope au niveau de l'élément déphaseur (1, 54, 73, 74).

3. Elément déphaseur (1, 54, 73, 74) selon la revendication 1 ou 2, dans lequel le moyen (2, 17, 18, 19) de génération d'un potentiel inhomogène est réalisé pour une génération d'un potentiel électrique ($U_B$).

4. Elément déphaseur (1, 54, 73, 74) selon l'une quelconque des revendications précédentes, dans lequel le moyen de génération d'un potentiel inhomogène est réalisé pour une génération d'un potentiel magnétique.

5. Elément déphaseur (1, 54, 73, 74) selon l'une quelconque des revendications précédentes, dans lequel l'élément déphaseur (1, 54, 73, 74) présente plusieurs ouvertures (2, 17, 18, 19).

6. Elément déphaseur (1, 54, 73, 74) selon l'une quelconque des revendications 1 à 4, dans lequel l'élément déphaseur (1, 54, 73, 74) présente exactement une ouverture (2, 17, 18, 19).

7. Elément déphaseur (1, 54, 73, 74) selon la revendication 5 ou 6, dans lequel

   - l'élément déphaseur (1) présente une première extension d'élément (E1) le long d'un premier axe (y) et une deuxième extension d'élément (E2) le long d'un deuxième axe (x),
   - le premier axe (y) est agencé de manière non parallèle au deuxième axe (x), et dans lequel
   - l'ouverture (2) s'étend aussi bien le long du premier axe (y) que le long du deuxième axe (x).

8. Elément déphaseur (1) selon la revendication 7, dans lequel l'ouverture (2) présente une première extension d'ouverture (O1) le long du premier axe (y) et une deuxième extension d'ouverture (02) le long du deuxième axe (x), la première extension d'ouverture (O1) étant plus grande que la deuxième extension d'ouverture (02).

9. Elément déphaseur (1) selon la revendication 7 ou 8, dans lequel le premier axe (y) est agencé de manière perpendiculaire au deuxième axe (x).

10. Elément déphaseur (1) selon l'une quelconque des revendications 7 à 9, dans lequel l'élément déphaseur (1) présente un troisième axe (z), qui passe de manière non parallèle aussi bien par rapport au premier axe (y) que par rapport au deuxième axe (x), le long duquel s'étend une troisième extension d'ouverture (E3).

11. Elément déphaseur (1) selon l'une quelconque des revendications précédentes, dans lequel l'ouverture (2, 18, 19) est réalisée en forme de fente.

12. Elément déphaseur (1) selon l'une quelconque des revendications précédentes, dans lequel l'ouverture (2, 18, 19) est réalisée sous une forme rectangulaire.

13. Elément déphaseur (1) selon l'une quelconque des revendications précédentes, dans lequel l'ouverture (18, 19) est réalisée en forme de croix.

14. Elément déphaseur (1) selon l'une quelconque des revendications précédentes, dans lequel l'élément déphaseur (1) est réalisé en plusieurs couches.

15. Elément déphaseur (1) selon l'une quelconque des revendications précédentes, dans lequel l'élément déphaseur (1) présente au moins une électrode (3, 9, 10, 12, 13, 14).

16. Elément déphaseur (1) selon la revendication 15, dans lequel l'électrode (12a à 12h, 14a à 14h) est segmentée.

17. Elément déphaseur (1) selon la revendication 15 ou 16, dans lequel une première électrode (12) et une deuxième électrode (14), qui peuvent être commandées de manière individuelle et peuvent être soumises de manière individuelle à différents potentiels, sont prévues dans un plan.

18. Elément déphaseur (1) selon l'une quelconque des revendications 15 à 17, dans lequel les électrodes (3, 9, 10, 12, 13, 14) ou au moins une parmi la première électrode (12) et la deuxième électrode (14) présentent un premier côté (3a) et un deuxième côté (3b) et dans lequel un premier isolant (6) est agencé au niveau du premier côté (3a).

**19.** Elément déphaseur (1) selon la revendication 18, dans lequel un deuxième isolant (7) est agencé au niveau du deuxième côté (3b).

**20.** Elément déphaseur (1) selon la revendication 18 ou 19, dans lequel une première unité de blindage (4) est agencée au niveau du premier isolant (6).

**21.** Elément déphaseur (1) selon la revendication 19 ou 20, dans lequel une deuxième unité de blindage (5) est agencé au niveau du deuxième Isolant (7).

**22.** Elément déphaseur (1) selon l'une quelconque des revendications précédentes, dans lequel l'élément déphaseur (1) présente une unité de dérive (22).

**23.** Elément déphaseur (1) selon l'une quelconque des revendications précédentes, dans lequel l'élément déphaseur (1) présente au moins un secteur (104, 105) avec un potentiel intérieur.

**24.** Système avec au moins un premier élément déphaseur (1, 73, 74) et avec au moins un deuxième élément déphaseur (1, 73, 74), dans lequel aussi bien le premier élément déphaseur (1, 73, 74) que le deuxième élément déphaseur (1, 73, 74) sont réalisés selon l'une quelconque des revendications précédentes.

**25.** Système selon la revendication 24, dans lequel

- le système présente un axe optique (72),
- le premier élément déphaseur (1, 73, 74) et le deuxième élément déphaseur (1, 73, 74) sont agencés le long de l'axe optique (72), et dans lequel
- le deuxième élément déphaseur (1, 74) est agencé en arrière du premier élément déphaseur (1, 73).

**26.** Appareil à faisceau de particules avec

- au moins un objectif (30, 50, 65), qui présente un plan focal arrière (33, 51, 66).
- au moins une première lentille de diffraction (34, 67) pour une représentation agrandie du plan focal arrière (33, 53, 66) de l'objectif (30, 50, 65) dans un plan d'image intermédiaire de diffraction (40, 59, 69, ZS)
- au moins une deuxième lentille de diffraction (41, 69), qui est agencée dans le plan d'image intermédiaire de diffraction (40, 69),
- au moins un élément multipolaire (36, 37, 43, 46, 47, 56 à 58, 61 à 63, Q1 à Q7), ainsi qu'avec
- au moins un élément déphaseur (1) selon l'une quelconque des revendications 1 à 23.

**27.** Appareil à faisceau de particules selon la revendication 26, dans lequel l'appareil à faisceau de particules présente un axe optique (32, z) et dans lequel le au moins un élément multipolaire (36, 37, 43, 46, 47, 56 à 58, 61 à 63, Q1 à Q7) est agencé à partir de l'objectif (30, 50, 65) en direction de la deuxième lentille de diffraction (41, 69).

**28.** Appareil à faisceau de particules selon la revendication 27, dans lequel

- l'appareil à faisceau de particules présente un premier élément multipolaire (36) est un deuxième élément multipolaire (37), et dans lequel
- la première lentille de diffraction (34), le premier élément multipolaire (36), le deuxième élément multipolaire (37) et le plan d'image intermédiaire de diffraction (40) sont agencés à partir de l'objectif (30) en direction de la deuxième lentille de diffraction (41),

**29.** Appareil à faisceau de particules selon la revendication 28, dans lequel l'appareil à faisceau de particules présente un troisième élément multipolaire (46), un quatrième élément multipolaire (47) ainsi qu'une lentille projective (48), le troisième élément multipolaire (46), le quatrième élément multipolaire (47) et le lentille projective (48) étant agencés à partir de la deuxième lentille de diffraction (41) en direction de la lentille projective (48).

**30.** Appareil à faisceau de particules selon la revendication 29, dans lequel un cinquième élément multipolaire (43) est agencé dans le secteur du plan d'image intermédiaire de diffraction (40).

**31.** Appareil à faisceau de particules selon la revendication 30, dans lequel le cinquième élément multipolaire (43) présente un premier élément sous-multipolaire (43a) et un deuxième élément sous-multipolaire (43b).

**32.** Appareil à faisceau de particules selon l'une quelconque des revendications 26 à 31, dans lequel l'élément multipolaire présente au moins un pole magnétique ou électrique.

**33.** Appareil à faisceau de particules selon l'une quelconque des revendications 26 à 32, dans lequel l'élément multipolaire (36, 37, 43, 46, 47, 56 à 58, 61 à 63, Q1 à Q7) ou au moins un des éléments multipolaires (36, 37, 43, 46, 47, 56 à 58, 61 à 63, Q1 à Q7) génère un champ quadripolaire.

**34.** Appareil à faisceau de particules selon la revendication 33, dans lequel l'élément multipolaire est réalisé en tant qu'élément quadripolaire (36, 37, 43, 46, 47, 56 à 58, 61 à 63, Q1 à Q7).

**35.** Appareil à faisceau de particules selon l'une quelconque des revendications 26 à 34, dans lequel un système de déviation double (38, 39, 44, 45) comprenant un champ dipolaire est affecté à l'élément multipolaire (36, 37, 46, 47).

**36.** Appareil à faisceau de particules selon l'une quelconque des revendications 26 à 35, dans lequel l'appareil à faisceau de particules présente au moins six éléments quadripolaire (56, 57, 58, 61, 62, 63), qui peuvent être excités de manière anti-symétrique par rapport au plan d'image intermédiaire de diffraction (59), un octupole (60) étant respectivement superposé à chacun des six éléments quadripolaires (56, 57, 58, 61, 62, 63) et au plan d'image intermédiaire de diffraction (59).

**37.** Appareil à faisceau de particules selon l'une quelconque des revendications 26 à 35, avec

- au moins un septuplet quadripolaire contenant six éléments quadripolaires (Q1 à Q7), les éléments quadripolaires (Q1 à Q7) pouvant être excités de manière symétrique par rapport au plan d'image intermédiaire de diffraction (ZS), ainsi qu'avec
- au moins cinq octupoles (O1 à 07) pouvant être excités à l'intérieur du septuplet quadripolaire.

**38.** Appareil à faisceau de particules selon la revendication 36 ou 37, dans lequel au moins un des octupoles (60, 01 à 07) est réalisé de manière électrique ou magnétique.

**39.** Appareil à faisceau de particules selon l'une quelconque des revendications 26 à 38, dans lequel l'appareil à faisceau de particules est muni d'un correcteur pour une correction des aberrations.

**40.** Appareil à faisceau de particules selon l'une quelconque des revendications 26 à 39, dans lequel l'appareil à faisceau de particules est réalisé en tant qu'appareil à faisceau d'électrons, en particulier en tant que microscope électronique à transmission.

Fig. 1

Fig 2

EP 1 959 475 B1

Fig.3

23

EP 1 959 475 B1

Fig.4

Potential

Phasenschiebung π/2

U_B

ideal

real

Potential

U_B

-U_B

x

Phasenschiebung π

x

**Fig. 5a**

**Fig. 5b**

**Fig. 6**

103

101

102

1

2

Fig. 7

Fig. 8

EP 1 959 475 B1

Fig. 9

Fig. 10

Fig. 11

Fig. 12a

19

Π/2

Π/2    Π/2

Π/2

18

3

2

Fig. 12b

105    Y

Π/2

Π/2    0    Π/2    X

18

Π/2

3

2

107

104    106

19

$U_{PH}$

1

<u>Fig. 13</u>

18

22

19

23

25

24

26

<u>Fig. 14</u>

27

28

29

30

31

32

X-Schnitt

Fig. 15a

Fig. 15b

X-Schnitt

Fig. 16a

Y-Schnitt

Fig. 16b

Fig. 17

Fig. 18

73

65

67

66

68

69

74

70

71

72

Fig. 19

**IN DER BESCHREIBUNG AUFGEFÜHRTE DOKUMENTE**

**In der Beschreibung aufgeführte Patentdokumente**

- EP 782170 A2
- WO 03068399 A2
- DE 10200645 A1
- DE 4204512 A1
- DE 10159454 A1

**In der Beschreibung aufgeführte Nicht-Patentliteratur**

- **E. MAJOROVITS.** *Ultramicroscopy,* 2007, vol. 107, 213-226